(19) Europäisches Patentamt
European Patent Office
Office européen des brevets

(11) EP 4 317 254 A1

(12) EUROPEAN PATENT APPLICATION
published in accordance with Art. 153(4) EPC

(43) Date of publication:
**07.02.2024 Bulletin 2024/06**

(21) Application number: **22774947.0**

(22) Date of filing: **01.03.2022**

(51) International Patent Classification (IPC):
***C08G 73/10*** *(2006.01)* ***C08J 5/18*** *(2006.01)*
***B32B 15/088*** *(2006.01)* ***H05K 1/03*** *(2006.01)*

(52) Cooperative Patent Classification (CPC):
**B32B 15/088; C08G 73/10; C08J 5/18; H05K 1/03**

(86) International application number:
**PCT/JP2022/008643**

(87) International publication number:
**WO 2022/202150 (29.09.2022 Gazette 2022/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.03.2021 JP 2021053994**
**02.07.2021 JP 2021110954**

(71) Applicant: **MITSUBISHI GAS CHEMICAL COMPANY, INC.**
**Chiyoda-ku**
**Tokyo 100-8324 (JP)**

(72) Inventors:
- **SATO, Yuuki**
  **Hiratsuka-shi, Kanagawa 254-0016 (JP)**
- **SAKAI, Atsushi**
  **Hiratsuka-shi, Kanagawa 254-0016 (JP)**

(74) Representative: **Vossius & Partner**
**Patentanwälte Rechtsanwälte mbB**
**Siebertstraße 3**
**81675 München (DE)**

# (54) METHOD FOR PRODUCING POLYIMIDE RESIN POWDER

(57) A method for producing a polyimide resin powder, the method including: a step of reacting a tetracarboxylic acid component (A) containing a tetracarboxylic dianhydride and a diamine component (B) containing an aliphatic diamine in the presence of a solvent (C) containing an alkylene glycol solvent represented by the formula (1), wherein the step includes: separately preparing a solution (a) containing the tetracarboxylic acid component (A) in the solvent (C) and a solution (b) containing the diamine component (B) in the solvent (C), and then adding the solution (b) to the solution (a) or adding the solution (a) to the solution (b) to prepare a solution (c) containing a polyimide resin precursor containing a polyamic acid; and then imidizing the polyimide resin precursor containing the polyamic acid by heating the solution (c) to deposit a polyimide resin powder in the solution, wherein the solution (c) has a solid content concentration of 15 to 25% by mass, and an average heating rate in a temperature range of 70 to 130°C during the heating of the solution (c) is 0.5 to 8 °C/min:

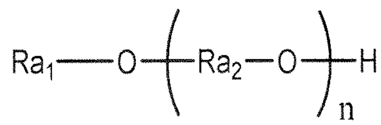

(1)

wherein $Ra_1$ represents a hydrogen atom or an alkyl group having from 1 to 4 carbon atoms, $Ra_2$ represents a linear alkylene group having from 2 to 6 carbon atoms, and n represents an integer of 1 to 3.

EP 4 317 254 A1

## Description

### Technical Field

The present invention relates to a method for producing a polyimide resin powder, a polyimide resin powder, and a resin film obtained using the polyimide resin powder.

### Background Art

A polyimide resin is a useful engineering plastic that has high thermal stability, high strength and high solvent resistance due to the stiffness, resonance stabilization and strong chemical bonds of the molecular chain thereof, and is being applied to a wide range of fields. A polyimide resin having crystallinity can be further enhanced in the heat resistance, the strength and the chemical resistance thereof, and thus is expected for applications as alternatives of metals or the like. While a polyimide resin has high heat resistance, however, it has the problems of exhibiting no thermoplasticity and having low molding processability.

Vespel (registered trademark), a highly heat-resistant resin, is known as a polyimide molding material (PTL 1). This resin is difficult to process by molding due to its very low flowability even at a high temperature, and is also disadvantageous in terms of cost because it requires molding under conditions of a high temperature and a high pressure for a prolonged period of time. In contrast to this, a resin having a melting point and flowability at a high temperature, such as a crystalline resin, may be processed by molding easily and inexpensively.

Thus, a polyimide resin having thermoplasticity has been reported in recent years. Such a thermoplastic polyimide resin is excellent in molding processability in addition to the original heat resistance of the polyimide resin. The thermoplastic polyimide resin is therefore applicable to a formed article for use in an inhospitable environment to which nylon or polyester, a general purpose thermoplastic resin, is inapplicable.

Thermoplastic polyimide resins can be formed into various shapes by heat melting. Further, if the thermoplastic polyimide resin can be recovered as a uniform powder, the recovered powder will be very useful because processing unevenness is less likely to occur during forming. In recent years, studies have also been conducted on methods for obtaining a uniform powdery thermoplastic polyimide resins.

For example, Patent Literature 2 discloses a method for producing a polyimide resin powder that includes a step of reacting a tetracarboxylic acid component (A) containing a tetracarboxylic dianhydride and a diamine component (B) containing an aliphatic diamine in the presence of a solvent (C) containing an alkylene glycol solvent represented by a specific formula. In Patent Literature 2, it is described that the powdery polyimide resin can be produced with almost no lumps.

In recent years, application of resin films obtained using a thermoplastic polyimide resin in high-frequency circuit boards is also being studied (see Patent Literature 3, for example). On the other hand, thermoplastic polyimide resins inherently have a high water absorption rate due to the polarity of the imide group, and thus it is known that when such a thermoplastic polyimide resin is used to obtain a resin film, the fluctuation of the dielectric constant due to water absorption is large.

### Citation List

#### Patent Literature

PTL 1: JP 2005-28524 A
PTL 2: WO 2015/020019
PTL 3: JP 2020-177987A

### Summary of Invention

#### Technical Problem

When using a forming material containing a thermoplastic polyimide resin powder to produce a film-like (including sheet-like) formed article (resin film) to be applied to a high-frequency circuit board or the like, there are normally methods such as: (i) obtaining the film-like formed article by feeding a forming material containing the powder into an extruder, directly extruding, and then performing various kinds of thermoforming, (ii) obtaining the film-like formed article by feeding a material containing the powder into an extruder, pelletizing, and then performing various kinds of thermoforming on

the pellets as the forming material, and (iii) obtaining the film-like formed article by direct compression-molding of a forming material containing the powder with a hot press apparatus.

However, if the particle size of the thermoplastic polyimide resin powder is too small, problems may arise, such as melt-kneading becomes difficult due to a deterioration in handleability when the thermoplastic polyimide resin powder is fed into the extruder, in particular the ability of the screw of the extruder to bite into the material. Further, when producing the thermoplastic polyimide resin powder, the filter cloth clogs during the filtration to remove the solvent, resulting in a decrease in productivity.

On the other hand, if the particle size of the thermoplastic polyimide resin powder is too large, a high-boiling point solvent used during production and moisture from water absorption tend to remain inside the particles. Therefore, problems can arise, such as more energy, for example, a higher drying temperature or a longer drying time, being required to remove the residual solution (high-boiling point solvent and moisture) that remains inside the particles in the drying process, and removal of the residual solution being difficult. In addition, if a large amount of residual solution remains inside the particles of the thermoplastic polyimide resin powder, a large amount of gas is generated during the process of obtaining the film-like formed article using the powder, which can result in problems such as molding defects, worse film appearance, discoloration/changes originating from deterioration due to the heating of the residual solution.

The polyimide resin powder described in Patent Literature 2 has been shown to have a suitable particle size distribution, but on the other hand, there has not been any particular consideration of a method for controlling the volume average particle size D50 within a specific range, and so there is room for further investigation.

Accordingly, an object of the present invention is to provide a method for producing a polyimide resin powder that easily controls the volume average particle size D50 within a specific range and has a good particle size distribution.

Solution to Problem

The present inventors have found that the aforementioned object can be attained by, in a method for producing a polyimide resin powder which includes a step of reacting a tetracarboxylic acid component and a diamine component in the presence of a specific solvent, setting the solid content concentration of a solution that is prepared in the step and contains a polyimide resin precursor containing a polyamic acid to be in a specific range, and when heating the solution (c) to imidize the polyimide resin precursor containing the polyamic acid, setting an average heating rate in a specific temperature range to be in a specific range.

That is, the present invention provides a method for producing a polyimide resin powder, the method including: a step of reacting a tetracarboxylic acid component (A) containing a tetracarboxylic dianhydride and a diamine component (B) containing an aliphatic diamine in the presence of a solvent (C) containing an alkylene glycol solvent represented by the formula (1), wherein the step includes: separately preparing a solution (a) containing the tetracarboxylic acid component (A) in the solvent (C) and a solution (b) containing the diamine component (B) in the solvent (C), and then adding the solution (b) to the solution (a) or adding the solution (a) to the solution (b) to prepare a solution (c) containing a polyimide resin precursor containing a polyamic acid; and then imidizing the polyimide resin precursor containing the polyamic acid by heating the solution (c) to deposit a polyimide resin powder in the solution,
wherein the solution (c) has a solid content concentration of 15 to 25% by mass, and an average heating rate in a temperature range of 70 to 130°C during the heating of the solution (c) is 0.5 to 8 °C/min:

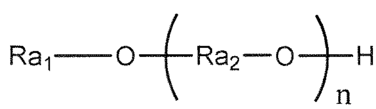

(1)

wherein $Ra_1$ represents a hydrogen atom or an alkyl group having from 1 to 4 carbon atoms, $Ra_2$ represents a linear alkylene group having from 2 to 6 carbon atoms, and n represents an integer of 1 to 3.

Advantageous Effects of Invention

According to the production method of the present invention, it is possible to obtain a polyimide resin powder having a volume average particle size D50 within a specific range (specifically from 5 to 50 μm) and a good particle size distribution. Further, according to the resin film obtained by using the polyimide resin powder having the specific composition obtained by the production method of the present invention, it is possible to suppress the increase in dielectric loss tangent under high temperatures.

The resin film can be applied to, for example, a high-frequency circuit board, a copper clad laminate (CCL), in particular a copper clad laminate that uses a low-roughness (arithmetic average roughness Ra = 1 μm or less, maximum

height Rz = 1 μm or less) copper foil, a printed circuit board, a transmission lines such as a coaxial line, a strip line, a microstrip line, a coplanar line, and a parallel line, a microwave antenna, a millimeter wave antenna, a waveguide slot antenna, a horn antenna, a lens antenna, a printed antenna, a triplate antenna, a microstrip antenna, a patch antenna, various sensors, an automotive radar, an aerospace radar, a semiconductor device material, a coating for a bearing, a heat insulating shaft, a tray, various belts such as a seamless belt, a heat-resistant low-dielectric tape, a heat-resistant low-dielectric tube, a low-dielectric wire coating material, a radome (radar dome), a 5G smartphone/5G terminal antenna board, a 6G smartphone/6G terminal antenna board, a chip-on-film (COF) flexible board, an optical communication module (TOSA/ROSA), a 77 GHz in-vehicle millimeter wave radar antenna board, a terahertz wave radar antenna board, an aircraft radar antenna board, a tracked vehicle antenna board, an 8K-TV cable, a WiGig antenna board, a tablet terminal, a laptop PC, a flat-screen TV, a roll-up TV, a mobile terminal or digital home appliance such as a digital camera, a macro cell base station, a small cell base station, a C-RAN base station, a commercial drone, a long-distance mobile drone, a surveillance camera, smart glasses, a smart watch, a wafers for a high-frequency device, a wireless communication device, a Wi-Fi chip, a touch sensor, an indoor server, an outdoor server, an industrial robot board, a home robot communication board, an artificial satellite, a space station communication device, and the like.

## Brief Description of Drawings

[Fig. 1] Fig. 1 shows the results of laser diffraction particle size distribution measurement of the polyimide resin powder obtained in Example 1.
[Fig. 2] Fig. 2 shows the results of laser diffraction particle size distribution measurement of the polyimide resin powder obtained in Example 2.
[Fig. 3] Fig. 3 shows the results of laser diffraction particle size distribution measurement of the polyimide resin powder obtained in Example 3.
[Fig. 4] Fig. 4 shows the results of laser diffraction particle size distribution measurement of the polyimide resin powder obtained in Example 4.
[Fig. 5] Fig. 5 shows the results of laser diffraction particle size distribution measurement of the polyimide resin powder obtained in Comparative Example 1.
[Fig. 6] Fig. 6 shows the results of laser diffraction particle size distribution measurement of the polyimide resin powder obtained in Comparative Example 2.
[Fig. 7] Fig. 7 shows the results of laser diffraction particle size distribution measurement of the polyimide resin powder obtained in Comparative Example 3.
[Fig. 8] Fig. 8 shows the results of laser diffraction particle size distribution measurement of the polyimide resin powder obtained in Comparative Example 4.
[Fig. 9] Fig. 9 shows the results of laser diffraction particle size distribution measurement of the polyimide resin powder obtained in Comparative Example 5.
[Fig. 10] Fig. 10 shows the results of laser diffraction particle size distribution measurement of the polyimide resin powder obtained in Comparative Example 6.
[Fig. 11] Fig. 11 shows the shows the measurement results of the dielectric constant P and the dielectric loss tangent Q of the resin film obtained in Example 1 at each temperature at a measurement frequency of 10 GHz.
[Fig. 12] Fig. 12 shows the shows the measurement results of the dielectric constant P and the dielectric loss tangent Q of the resin film obtained in Example 1 at each temperature at a measurement frequency of 20 GHz.

## Description of Embodiments

### <Method for producing a polyimide resin powder>

The method for producing a polyimide resin powder according to the present invention includes a step of reacting a tetracarboxylic acid component (A) containing a tetracarboxylic dianhydride and a diamine component (B) containing an aliphatic diamine in the presence of a solvent (C) containing an alkylene glycol solvent represented by the formula (1). The step includes separately preparing a solution (a) containing the tetracarboxylic acid component (A) in the solvent (C) and a solution (b) containing the diamine component (B) in the solvent (C), and then adding the solution (b) to the solution (a) or adding the solution (a) to the solution (b) to prepare a solution (c) containing a polyimide resin precursor containing a polyamic acid, and then imidizing the polyimide resin precursor containing the polyamic acid by heating the solution (c) to deposit a polyimide resin powder in the solution. The solution (c) has a solid content concentration of 15 to 25% by mass. An average heating rate in a temperature range of 70 to 130°C during the heating of the solution (c) is 0.5 to 8 °C/min.

The "polyimide resin precursor" herein refers to a product produced by the reaction of the tetracarboxylic acid component (A), the diamine component (B), and the solvent (C) containing an alkylene glycol solvent, and examples thereof include, in addition to a polyamic acid, an amide acid salt, a polyamic acid salt, a polyamic acid ester, a polyamic acid amide, and the like:

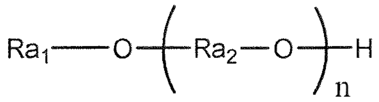

(1)

wherein $Ra_1$ represents a hydrogen atom or an alkyl group having from 1 to 4 carbon atoms, $Ra_2$ represents a linear alkylene group having from 2 to 6 carbon atoms, and n represents an integer of 1 to 3.

The "solid content concentration of the solution (c) that contains a polyimide resin precursor containing a polyamic acid" herein refers to the proportion of the solute in the solution (c) (% by mass in terms of charged amount). In addition, "solute" refers to the tetracarboxylic acid component (A), the diamine component (B), the end capping agent and the like, which are the starting material of the polyamic acid, and "solution (c)" refers to the total of the solute and the solvent including the solvent (C) containing an alkylene glycol solvent.

In the method for producing the polyimide resin powder of the present invention, the solution (a) containing the tetracarboxylic acid component (A) in the solvent (C) and a solution (b) containing the diamine component (B) in the solvent (C) are prepared separately, then the solution (b) is added to the solution (a) or the solution (a) is added to the solution (b) to prepare a solution (c) containing a polyimide resin precursor containing the polyamic acid (step 1). Then, the polyimide resin precursor containing the polyamic acid is imidized in the solution (c) by heating the solution (c) to deposit the polyimide resin powder in the solution, thereby synthesizing the polyimide resin powder (step 2).

In the method for producing the polyimide resin powder of the present invention, the solid content concentration of the solution (c) containing the polyamic acid in step 1 is set to 15 to 25% by mass, and when the solution (c) is heated in step 2, the average heating rate of the solution (c) in the temperature range of 70 to 130°C is set to 0.5 to 8°C/min. As a result, although the mechanism by which the polyimide resin powder having a volume average particle size D50 controlled within a specific range (specifically, 5 to 50 μm) and having a good particle size distribution is obtained is not necessarily clear, it is thought to be as follows.

When the temperature of the solution (c) containing the polyimide resin precursor containing the polyamic acid is in the range of 70 to 130°C, imidization of the polyimide resin precursor containing the polyamic acid progresses, and a polyimide resin powder (hereinafter, also referred to as "deposit") is deposited in the solution.

The solvent (C), which is the solvent of the solution (c), has a high compatibility with the polyamic acid, but a low compatibility with the deposit that is deposited as the imidization rate increases. On the other hand, the solubility of the deposit increases when the temperature in the system is high, but the solubility decreases when the temperature in the system is low.

Therefore, it is considered that the deposit is suddenly formed at the timing when the balance between the increase in solubility due to the increase in temperature in the system and the decrease in compatibility due to the increase in the imidization rate is lost. Moreover, it is considered that the timing at which this balance is lost can be controlled by the solid content concentration of the solution (c) and the average heating rate in the temperature range of 70 to 130°C where imidization progresses.

For example, it is considered that when the heating rate during the heating of the solution (c) is slow, because the temperature in the system rises gently during the process of imidization, many crystals (seed crystals) that seed the deposit are formed at the stage prior to the increase in imidization rate, and as a result the particle size of the individual powder particles in the deposit tends not to grow to be large.

On the other hand, it is considered that when the heating rate during the heating of the solution (c) is fast, because the temperature in the system rises quickly during the process of imidization, formation of seed crystals at the stage prior to the increase in imidization rate is avoided, and deposition begins at the stage where imidization has progressed to a certain extent, so that the particle size of the individual powder particles in the deposit tends to grow to be large.

In the method for producing the polyimide resin powder of the present invention, the solid content concentration of the solution (c) containing the polyimide resin precursor containing the polyamic acid prepared in step 1 is 15 to 25% by mass, preferably 15 to 23% by mass, and more preferably 17 to 23% by mass.

If the solid content concentration is less than the above range (less than 15% by mass), the volume average particle size D50 of the polyimide resin powder may exceed 50 μm, or the particle size distribution of the polyimide resin powder may become multimodal, for example, trimodal or more.

On the other hand, if the solid content concentration exceeds the above range (exceeds 25% by mass), the shape of the particle size distribution of the polyimide resin powder may be a bimodal distribution and very broad, or may be very broad even though it is unimodal.

In the method for producing the polyimide resin powder of the present invention, when heating the solution (c) in step 2, the average heating rate in the temperature range of the solution (c) of 70 to 130°C is 0.5 to 8 °C/min, preferably 0.8 to 6 °C/min, and more preferably 0.8 to 4 °C/min.

If the average heating rate is less than the above range (less than 0.5 °C/min), the particle size distribution of the polyimide resin powder may be a bimodal distribution and very broad, or may be very broad even though it is unimodal.

On the other hand, if the average heating rate exceeds the above range (exceeds 8 °C/min), the volume average particle size D50 of the polyimide resin powder may exceed 50 μm.

In the step of heating the solution (c) in the present invention, when the temperature of the solution (c) is in the range of 70 to 130°C, as described above, heating is performed at the specific average heating rate.

On the other hand, when the temperature of the solution (c) is in a range exceeding 130°C, the average heating rate may be the same as in the range where the temperature of the solution (c) is 70 to 130°C, but from the viewpoint of improving the production rate, it is preferred that the rate does not decrease too much, and from the viewpoint of suppressing bumping of the water produced as a by-product during the reaction, it is preferred that the rate does not increase too much. Specifically, the average heating rate is preferably 0.9 to 5 °C/min, and more preferably 1.0 to 4 °C/min.

Further, in the range where the temperature of the solution (c) exceeds 130°C, from the viewpoint of sufficiently growth of the molecules or sufficient progress of the imidization, the heating and holding temperature and the time are preferably heating up to 160°C, more preferably up to 180°C, and further preferably up to 190°C, and holding that temperature for preferably 10 to 120 minutes, and more preferably 30 to 60 minutes.

The solvent (C) includes the alkylene glycol solvent represented by the formula (1). In the production of a polyimide resin using an aliphatic diamine as the diamine component of the starting material, a powdery polyimide resin can be obtained by reacting the tetracarboxylic acid component (A) and the diamine component (B) in the presence of such a specific solvent.

In order to obtain a uniform powdery polyimide resin, in a one-pot reaction, it is though that it is desirable for the solvent to possess two characteristics, namely, (i) uniformly dissolves the polyamic acid or uniformly disperses the nylon salt, and (ii) does not dissolve or swell the polyimide resin at all. The solvent (C) generally satisfies these two characteristics. If (i) is incomplete, aggregation and clumping occur before imidization, and if (ii) is incomplete, aggregation and clumping occur after imidization.

From the viewpoint of enabling a polymerization reaction under normal pressure and high temperature conditions, the above alkylene glycol solvent preferably has a boiling point of 140°C or higher, more preferably 160°C or higher, and even more preferably 180°C or higher.

$Ra_1$ in the formula (1) represents a hydrogen atom or an alkyl group having from 1 to 4 carbon atoms, preferably an alkyl group having from 1 to 4 carbon atoms, and more preferably a methyl group or an ethyl group.

$Ra_2$ in the formula (1) represents a linear alkylene group having from 2 to 6 carbon atoms, preferably a linear alkylene group having from 2 to 3 carbon atoms, and more preferably an ethylene group.

In the formula (1), n represents an integer of 1 to 3, and preferably 2 or 3.

Specific examples of the alkylene glycol solvent include ethylene glycol monomethyl ether, diethylene glycol monomethyl ether (also referred to as 2-(2-methoxyethoxy)ethanol), triethylene glycol monomethyl ether (also referred to as 2-[2-(2-methoxyethoxy)ethoxy]ethanol), ethylene glycol monoethyl ether, diethylene glycol monoethyl ether (also referred to as 2-(2-ethoxyethoxy)ethanol), ethylene glycol monoisopropyl ether, diethylene glycol monoisopropyl ether, triethylene glycol monoisopropyl ether, ethylene glycol monobutyl ether, diethylene glycol monobutyl ether, triethylene glycol monobutyl ether, ethylene glycol monoisobutyl ether, diethylene glycol monoisobutyl ether, ethylene glycol monoisobutyl ether, ethylene glycol, 1,3-propanediol, and the like. These solvents may be used alone, or two or more solvents selected from among them may be used in combination. Among these solvents, at least one selected from the group consisting of 2-(2-methoxyethoxy)ethanol, 2-[2-(2-methoxyethoxy)ethoxy]ethanol, 2-(2-ethoxyethoxy)ethanol, and 1,3-propanediol is preferred, and at least one selected from the group consisting of 2-(2-methoxyethoxy)ethanol and 2-(2-ethoxyethoxy)ethanol is more preferred.

The content of the alkylene glycol solvent in the solvent (C) is preferably 30% by mass or more, more preferably 50% by mass or more, further preferably 75% by mass or more, and still further preferably 95% by mass or more. The solvent (C) may be composed only of the alkylene glycol solvents described above.

In a case where the solvent (C) contains the above-described alkylene glycol solvent and another solvent, specific examples of the "other solvent" include water, toluene, xylene, acetone, hexane, heptane, chlorobenzene, methanol, ethanol, n -propanol, isopropanol, N-methyl-2-pyrrolidone, N,N-dimethylacetamide, N,N-diethylacetamide,

N,N-dimethylformamide, N,N-diethylformamide, N-methylcaprolactam, hexamethylphosphorus amide, tetramethylene sulfone, dimethyl sulfoxide, o-cresol, m-cresol, p-cresol, phenol, p-chlorophenol, 2-chloro-4-hydroxytoluene, diglyme, triglyme, tetraglyme, dioxane, γ-butyrolactone, dioxolane, cyclohexanone, cyclopentanone, dichloromethane, chloroform, 1,2-dichloroethane, 1,1,2-trichloroethane, dibromomethane, tribromomethane, 1,2-dibromoethane, 1,1,2-tribromoethane, 2-ethylhexanol, and the like. These solvents may be used alone, or two or more solvents selected from among them may be used in combination. Among these solvents, 2-ethylhexanol is preferred. That is, the solvent (C) preferably contains 2-ethylhexanol in addition to the above-described alkylene glycol solvent.

Although the solvent (C) preferably does not contain water, the solvent may contain water as long as a long-chain polyamic acid is formed as described above. Specifically, the water content is preferably 10% by mass or less, more preferably 5% by mass or less, further preferably 1% by mass or less, and particularly preferably 0% by mass.

The diamine component (B) contains an aliphatic diamine. The present invention enables the production of a powdered polyimide resin in the production of a polyimide resin using an aliphatic diamine as the diamine component of the starting material. By using an aliphatic diamine as the diamine component of the starting material, the polyimide resin powder is endowed with thermoformability.

Examples of the aliphatic diamine include a diamine containing at least one alicyclic hydrocarbon structure and a chain aliphatic diamine. The diamine component (B) preferably contains, as the aliphatic diamine, a diamine containing at least one alicyclic hydrocarbon structure and a chain aliphatic diamine, and more preferably contains a diamine (B1) represented by the formula (B1-1) and a diamine (B2) represented by the formula (B2-1):

$$H_2N\text{-}R_1\text{-}NH_2 \qquad (B1\text{-}1)$$

$$H_2N\text{-}R_2\text{-}NH_2 \qquad (B2\text{-}1)$$

wherein $R_1$ represents a divalent group having from 6 to 22 carbon atoms containing at least one alicyclic hydrocarbon structure, and $R_2$ represents a divalent chain aliphatic group having from 5 to 20 carbon atoms.

The diamine containing at least one alicyclic hydrocarbon structure and the chain aliphatic diamine are described below.

The diamine containing at least one alicyclic hydrocarbon structure is preferably a diamine (B1) represented by the following formula (B1-1):

$$H_2N\text{-}R_1\text{-}NH_2 \qquad (B1\text{-}1)$$

wherein $R_1$ represents a divalent group having from 6 to 22 carbon atoms containing at least one alicyclic hydrocarbon structure.

The alicyclic hydrocarbon structure herein means a ring derived from an alicyclic hydrocarbon compound, and the alicyclic hydrocarbon compound may be either saturated or unsaturated and may be either monocyclic or polycyclic.

Examples of the alicyclic hydrocarbon structure include a cycloalkane ring, such as a cyclohexane ring, a cycloalkene ring, such as cyclohexene, a bicycloalkane ring, such as a norbornane ring, and a bicycloalkene ring, such as norbornene, but the alicyclic hydrocarbon structure is not limited thereto. Among these, a cycloalkane ring is preferred, a cycloalkane ring having from 4 to 7 carbon atoms is more preferred, and a cyclohexane ring is further preferred.

$R_1$ has from 6 to 22 carbon atoms, and preferably from 8 to 17 carbon atoms.

$R_1$ contains at least one alicyclic hydrocarbon structure, and preferably from 1 to 3 alicyclic hydrocarbon structures.

$R_1$ is preferably a divalent group represented by the following formula (R1-1) or (R1-2), and more preferably a divalent group represented by the following formula (RI-3):

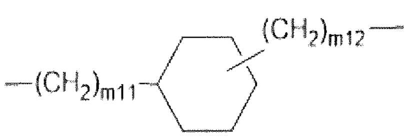

(R1-1)

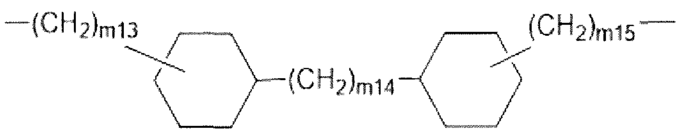

(R1-2)

wherein $m_{11}$ and $m_{12}$ each independently represent an integer of 0-2, and preferably 0 or 1; and $m_{13}$ to $m_{15}$ each independently represent an integer of 0-2, and preferably 0 or 1.

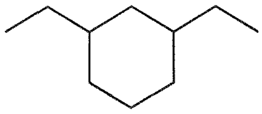

(R1-3)

In the divalent group represented by the formula (R1-3), the conformation of the two methylene groups with respect to the cyclohexane ring may be either cis or trans, and the ratio of cis and trans may be an arbitrary value.

The diamine (B1) is preferably represented by the following formula (B1-2):

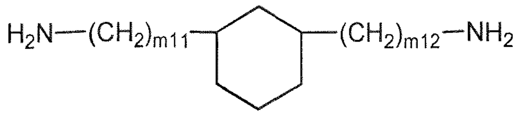

(B1-2)

wherein $m_{11}$ and $m_{12}$ each independently represent an integer of 0-2, and preferably 0 or 1.

Specific examples of the diamine (B1) include 1,2-bis(aminomethyl)cyclohexane, 1,3-bis(aminomethyl)cyclohexane, 1,4-bis(aminomethyl)cyclohexane, 1,2-cyclohexanediamine, 1,3-cyclohexanediamine, 1,4-cyclohexanediamine, 4,4'-diaminodicyclohexylmethane, 4,4'-methylenebis(2-methylcyclohexylamine), carvone diamine, limonene diamine, isophorone diamine, norbornane diamine, bis(aminomethyl)tricyclo[5.2.1.0$^{2,6}$]decane, 3,3'-dimethyl-4,4'-diaminodicyclohexylmethane, 4,4'-diaminodicyclohexylpropane, and the like. These compounds may be used solely or may be used as a combination of two or more compounds selected therefrom. Among these, 1,3-bis(aminomethyl)cyclohexane is preferably used. A diamine containing an alicyclic hydrocarbon structure generally has conformational isomers, and the ratio of the cis isomer and the trans isomer is not particularly limited. It is also known that less symmetrical diamines generally tend to increase the free volume of resins. Therefore, it is considered that 1,3-bis(aminomethyl)cyclohexane, which has a bulky structure and low symmetry, will tend to contribute to a low dielectric constant, and is thus more preferable.

The chain aliphatic diamine is preferably a diamine (B2) represented by the following formula (B2-1):

$$H_2N\text{-}R_2\text{-}NH_2 \qquad (B2\text{-}1)$$

wherein $R_2$ represents a divalent chain aliphatic group having from 5 to 16 carbon atoms.

The chain aliphatic group herein means a group derived from a chain aliphatic compound, and the chain aliphatic compound may be either saturated or unsaturated, may be in the form of either linear or branched chain, and may contain a hetero atom, such as an oxygen atom.

$R_2$ is preferably an alkylene group having from 5 to 16 carbon atoms, more preferably an alkylene group having from 6 to 14 carbon atoms, further preferably an alkylene group having from 7 to 12 carbon atoms, and particularly preferably an alkylene group having from 8 to 10 carbon atoms. The alkylene group may be either a linear alkylene group or a branched alkylene group, and is preferably a linear alkylene group.

$R_2$ preferably represents at least one selected from the group consisting of an octamethylene group and a decamethylene group, and particularly preferably represents an octamethylene group.

Another suitable embodiment of $R_2$ is a divalent chain aliphatic group having from 5 to 16 carbon atoms containing an ether group (preferably from 6 to 14 carbon atoms, and more preferably from 7 to 12 carbon atoms). Preferred examples of the group include a divalent group represented by the following formula (R2-1) or (R2-2):

$$\text{-}(CH_2)_{m21}\text{-}O\text{-}(CH_2)_{m22}\text{-} \qquad (R2\text{-}1)$$

$$\text{-}(CH_2)_{m23}\text{-}O\text{-}(CH_2)_{m24}\text{-}O\text{-}(CH_2)m_{25}\text{-} \qquad (R2\text{-}2)$$

wherein $m_{21}$ and $m_{22}$ each independently represent an integer of 1-15, preferably 1-13, more preferably 1-11, and further preferably 1-9; and $m_{23}$ to $m_{25}$ each independently represent an integer of 1-14, preferably 1-12, more preferably 1-10, and further preferably 1-8.

$R_2$ represents a divalent chain aliphatic group having from 5 to 16 carbon atoms (preferably from 6 to 14 carbon atoms, more preferably from 7 to 12 carbon atoms, and further preferably from 8 to 10 carbon atoms), and therefore $m_{21}$ and $m_{22}$ in the formula (R2-1) are selected so that the divalent group represented by the formula (R2-1) has from

5 to 16 carbon atoms (preferably from 6 to 14 carbon atoms, more preferably from 7 to 12 carbon atoms, and further preferably from 8 to 10 carbon atoms), i.e., $m_{21}$ + $m_{22}$ is from 5 to 16 (preferably 6 to 14, more preferably 7 to 12, and further preferably 8 to 10).

Similarly, $m_{23}$ to $m_{25}$ in the formula (R2-2) are selected so that the divalent group represented by the formula (R2-2) has from 5 to 16 carbon atoms (preferably from 6 to 14 carbon atoms, more preferably from 7 to 12 carbon atoms, and further preferably from 8 to 10 carbon atoms), i.e., $m_{23}$ + $m_{24}$ + $m_{25}$ is from 5 to 16 (preferably from 6 to 14 carbon atoms, more preferably from 7 to 12 carbon atoms, and further preferably from 8 to 10 carbon atoms).

Specific examples of the diamine (B2) include 1,5-pentamethylenediamine, 2-methylpentane-1,5-diamine, 3-methylpentane-1,5-diamine, 1,6-hexamethylenediamine, 1,7-heptamethylenediamine, 1,8-octamethylenediamine, 1,9-nonamethylenediamine, 1,10-decamethylenediamine, 1,11-undecamethylenediamine, 1,12-dodecamethylenediamine, 1,13-tridecamethylenediamine, 1,14-tetradecamethylenediamine, 1,16-hexadecamethylenediamine, 2,2'-(ethylenedioxy)bis(ethyleneamine), and the like. These compounds may be used alone, or two or more compounds selected from among these may be used in combination. Among these, a chain aliphatic diamine having from 8 to 10 carbon atoms can be preferably used, and at least one selected from the group consisting of 1,8-octamethylenediamine and 1,10-decamethylenediamine can be particularly preferably used.

The diamine component (B) preferably contains, as the aliphatic diamine, the above-described diamine (B1) and the above-described diamine (B2), and more preferably contains 1,3-bis(aminomethyl)cyclohexane and 1,8-octamethylene diamine.

From the viewpoint of obtaining a polyimide resin powder suitable for producing a high-frequency circuit board, which will be described later, the amount of the diamine (B1) with respect to the total amount of the diamine (B1) and the diamine (B2) is preferably 20 to 70 mol%, more preferably 20 to 65 mol%, further preferably 20 to 60 mol%, still further preferably 20 to 50 mol%, and even still further preferably 20 mol% or more and less than 40 mol%.

The diamine component (B) may be composed only of an aliphatic diamine, or may contain a diamine containing an aromatic ring in addition to the aliphatic diamine.

The diamine containing an aromatic ring is preferably a diamine containing at least one aromatic ring, and more preferably is a diamine (B3) represented by the following formula (B3-1).

$$H_2N\text{-}R_3\text{-}NH_2 \qquad (B3\text{-}1)$$

wherein $R_3$ is a divalent group having from 6 to 22 carbon atoms containing at least one aromatic ring.

The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$R_3$ has from 6 to 22 carbon atoms, and preferably has from 6 to 18 carbon atoms.

$R_3$ contains at least one aromatic ring, and preferably contains from 1 to 3 aromatic rings.

The aromatic ring may also be bonded to a monovalent or divalent electron-withdrawing group. Examples of the monovalent electron-withdrawing group include a nitro group, a cyano group, a p-toluenesulfonyl group, a halogen, an alkyl halide group, a phenyl group, an acyl group, and the like. Examples of the divalent electron-withdrawing group include alkylene halide groups such as alkylene fluoride groups (e.g., $-C(CF_3)_2-$ and - $(CF_2)_p-$ (wherein p is an integer of 1-10)), as well as -CO-, $-SO_2-$, -SO-, -CONH-, -COO-, and the like.

$R_3$ is preferably a divalent group represented by the following formula (R3-1) or (R3-2):

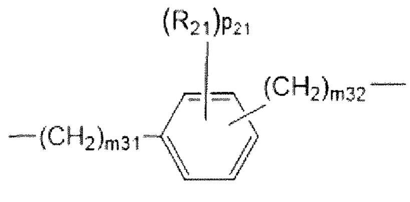

(R3-1)

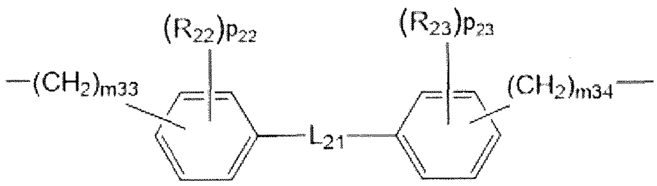

(R3-2)

wherein $m_{31}$ and $m_{32}$ each independently represent an integer of 0-2, and preferably 0 or 1; $m_{33}$ and $m_{34}$ each independently represent an integer of 0-2, and preferably 0 or 1; $R_{21}$, $R_{22}$ and $R_{23}$ each independently represent an alkyl group having from 1 to 4 carbon atoms, an alkenyl group having from 2 to 4 carbon atoms or an alkynyl group having from 2 to 4 carbon atoms; $p_{21}$, $p_{22}$ and $p_{23}$ each represent an integer of 0-4, and preferably 0; and $L_{21}$ represents a single bond, an ether group, a carbonyl group or an alkylene group having from 1 to 4 carbon atoms.

$R_3$ is a divalent group having from 6 to 22 carbon atoms containing at least one aromatic ring, and therefore $m_{31}$, $m_{32}$, $R_{21}$ and $P_{21}$ in the formula (R3-1) are selected in such a manner that the divalent group represented by the formula (R3-1) has from 6 to 22 carbon atoms.

Similarly, $L_{21}$, $m_{33}$, $m_{34}$, $R_{22}$, $R_{23}$, $p_{22}$ and $p_{23}$ in the formula (R3-2) are selected in such a manner that the divalent group represented by the formula (R3-2) has from 12 to 22 carbon atoms.

Specific examples of the diamine (B3) include orthoxylylenediamine, metaxylylenediamine, paraxylylenediamine, 1,2-diethynylbenzenediamine, 1,3-diethynylbenzenediamine, 1,4-diethynylbenzenediamine, 1,2-diaminobenzene, 1,3-diaminobenzene, 1,4-diaminobenzene, 4,4'-diaminodiphenyl ether, 3,4'-diaminodiphenyl ether, 4,4'-diaminodiphenylmethane, $\alpha,\alpha'$-bis(4-aminophenyl)-1,4-diisopropylbenzene, $\alpha,\alpha'$-bis(3-aminophenyl)-1,4-diisopropylbenzene, 2,2'-bis[4-(4-aminophenoxy)phenyl]propane, 2,6-diaminonaphthalene, 1,5-diaminonaphthalene, and the like.

When the diamine component (B) contains both an aliphatic diamine and a diamine containing an aromatic ring, it is preferred that the diamine component (B) further contain the diamine (B3) in addition to the diamine (B1) and the diamine (B2), and that the amount of the diamine (B3) be 25 mol% or less with respect to the total amount of the diamine (B1) and the diamine (B2). On the other hand, the lower limit is not particularly limited as long as the amount exceeds 0 mol%.

The diamine component (B) may contain a diamine (B4) represented by the following formula (B4-1):

$$H_2N\text{-}R_4\text{-}NH_2 \qquad \text{(B4-1)}$$

wherein $R_4$ represents a divalent group containing $-SO_2-$ or $-Si(R_x)(R_y)O-$; and $R_x$ and $R_y$ each independently represent a chain aliphatic group having from 1 to 3 carbon atoms, or a phenyl group.

However, from the viewpoint of the thennoformability of the polyimide resin powder obtained, the content of the aliphatic diamine, preferably the total content of the diamine (B1) and the diamine (B2), and more preferably the total content of 1,3-bis(aminomethyl)cyclohexane and 1,8-octamethylenediamine, in the diamine component (B) is preferably 50 mol% or more, more preferably 70 mol% or more, further preferably 80 mol % or more, and still further preferably 90 mol% or more, and 100 mol% or less, with respect to the total number of moles of the diamine in the diamine component (B).

The tetracarboxylic acid component (A) contains a tetracarboxylic dianhydride. The tetracarboxylic dianhydride is preferably a tetracarboxylic dianhydride containing at least one aromatic ring, and more preferably a tetracarboxylic dianhydride represented by the formula (A-1):

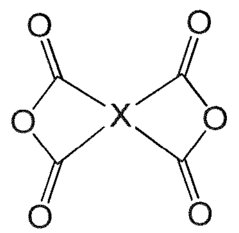

(A-1)

wherein $X_1$ is a tetravalent group having from 6 to 22 carbon atoms containing at least one aromatic ring.

$X_1$ is a tetravalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$X_1$ has from 6 to 22 carbon atoms, and preferably has from 6 to 18 carbon atoms.

$X_1$ contains at least one aromatic ring, and preferably contains from 1 to 3 aromatic rings.

$X_1$ is preferably a tetravalent group represented by one of the following formulae (X-1) to (X-4):

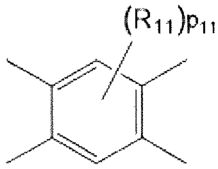

(X-1)

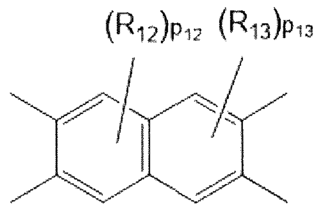

(X-2)

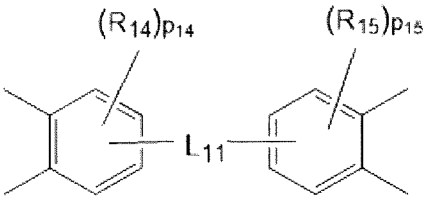

(X-3)

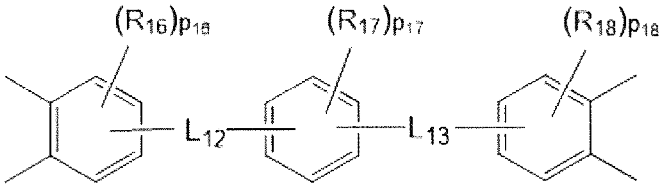

(X-4)

wherein $R_{11}$ to $R_{18}$ each independently represent an alkyl group having from 1 to 4 carbon atoms; $p_{11}$ to $p_{13}$ each independently represent an integer of 0-2, and preferably 0; $p_{14}$, $p_{15}$, $p_{16}$ and $p_{18}$ each independently represent an integer of 0-3, and preferably 0; $p_{17}$ represents an integer of 0-4, and preferably 0; and $L_{11}$ to $L_{13}$ each independently represent a single bond, an ether group, a carbonyl group or an alkylene group having from 1 to 4 carbon atoms.

X is a tetravalent group having from 6 to 22 carbon atoms containing at least one aromatic ring, and therefore $R_{12}$, $R_{13}$, $p_{12}$ and $p_{13}$ in the formula (X-2) are selected in such a manner that the tetravalent group represented by the formula (X-2) has from 10 to 22 carbon atoms.

Similarly, $L_{11}$, $R_{14}$, $R_{15}$, $p_{14}$ and $p_{15}$ in the formula (X-3) are selected in such a manner that the tetravalent group represented by the formula (X-3) has from 12 to 22 carbon atoms, and $L_{12}$, $L_{13}$, $R_{16}$, $R_{17}$, $R_{18}$, $p_{16}$, $p_{17}$ and $p_{18}$ in the formula (X-4) are selected in such a manner that the tetravalent group represented by the formula (X-4) has from 18 to 22 carbon atoms.

X is particularly preferably a tetravalent group represented by the following formula (X-5) or (X-6):

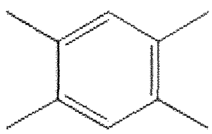

(X-5)

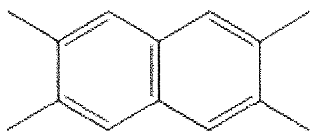

(X-6)

Specific examples of tetracarboxylic dianhydride include pyromellitic dianhydride, 2,3,5,6-toluenetetracarboxylic dianhydride, 3,3',4,4'-diphenyl diphenylsulfonetetracarboxylic dianhydride, 3,3',4,4'-benzophenonetetracarboxylic dianhydride, 3,3',4,4'-biphenyltetracarboxylic dianhydride, 1,4,5,8-naphthalenetetracarboxylic dianhydride, and the like. These tetracarboxylic dianhydrides may be used alone or two or more types may be used in combination. Among these, pyromellitic dianhydride is particularly preferred.

The tetracarboxylic acid component (A) may contain, in addition to the tetracarboxylic dianhydride, a derivative of tetracarboxylic dianhydride (a tetracarboxylic acid and/or an alkyl ester of a tetracarboxylic acid).

Examples of the tetracarboxylic acid include pyromellitic acid, 2,3,5,6-toluenetetracarboxylic acid, 3,3',4,4'-benzophenonetetracarboxylic acid, 3,3',4,4'-biphenyltetracarboxylic acid, 1,4,5,8-naphthalenetetracarboxylic acid, and the like. Among these, pyromellitic acid is particularly preferred.

Examples of the alkyl ester of a tetracarboxylic acid include dimethyl pyromellitate, diethyl pyromellitate, dipropyl pyromellitate, diisopropyl pyromellitate, dimethyl 2,3,5,6-toluenetetracarboxylate, dimethyl 3,3',4,4'-diphenylsulfonetetracarboxylate, dimethyl 3,3',4,4'-benzophenonetetracarboxylate, dimethyl 3,3',4,4'-biphenyltetracarboxylate, dimethyl 1,4,5,8 - Naphthalenetetracarboxylate, and the like. In the alkyl ester of a tetracarboxylic acid, the alkyl group preferably has 1 to 3 carbon atoms.

These tetracarboxylic acids and derivatives thereof may be used alone, or two or more types may be used in combination.

The proportion of the tetracarboxylic acid in the tetracarboxylic acid component (A) is preferably as low as possible, preferably 50 mol% or less, more preferably 30 mol% or less, and particularly preferably 0 mol%.

In the production of the polyimide resin powder, the charged amount ratio of the tetracarboxylic acid component (A) and the diamine component (B) is preferably 0.9 to 1.1 mol of the diamine component (B) per 1 mol of the tetracarboxylic acid component (A).

In the production of the polyimide resin powder of the present invention, an end capping agent may be mixed in addition to the tetracarboxylic acid component (A) and the diamine component (B). The end capping agent is preferably at least one selected from the group consisting of a monoamine and a dicarboxylic acid. It is sufficient for the amount of the end capping agent used to be an amount in which a desired amount of the end group can be introduced into the polyimide resin. This used amount is, based on one mole of the tetracarboxylic acid (A), preferably from 0.0001 to 0.1 moles, more preferably from 0.001 to 0.06 moles, and further preferably from 0.002 to 0.035 moles.

Examples of the monoamine end capping agent include aliphatic monoamines such as methylamine, ethylamine, propylamine, butylamine, n-pentylamine, n-hexylamine, n-heptylamine, n-octylamine, n-nonylamine, n-decylamine, n-undecylamine, laurylamine, n-tridecylamine, n-tetradecylamine, isopentylamine, neopentylamine, 2-methylpentylamine, 2-methylhexylamine, 2-ethylpentylamine, 3-ethylpentylamine, isooctylamine, 2-ethylhexylamine, 3-ethylhexylamine, isononylamine, 2-ethyloctylamine, isodecylamine, isododecylamine, isotridecylamine, and isotetradecylamine; and aromatic monoamines such as benzylamine, 4-methylbenzylamine, 4-ethylbenzylamine, 4-dodecylbenzylamine, 3-methylbenzylamine, 3-ethylbenzylamine, aniline, 3-methylaniline, and 4-methylaniline.

As other monoamine end capping agents, it is preferable to use a monoamine having a halogen element such as fluorine because low dielectric properties tend to be obtained. Specific examples include 2-trifluoromethylaniline, 3-trifluoromethylaniline, 4-trifluoromethylaniline, 2,3-bis(trifluoromethyl)aniline, 2,4-bis(trifluoromethyl)aniline, 2,5-bis(trifluoromethyl)aniline, 2,6-bis(trifluoromethyl)aniline, 3,4-bis(trifluoromethyl)aniline, 3,5-bis(trifluoromethyl)aniline, 2,3,4-tris(trifluoromethyl)aniline, 2,3,5-tris(trifluoromethyl)aniline, 2,3,6-tris(trifluoromethyl)aniline, 2,4,5-tris(trifluoro methyl)aniline, 2,4,6-tris(trifluoromethyl)aniline, 3,4,5-tris(trifluoromethyl)aniline, 2,3,4,5-tetrakis(trifluoromethyl)aniline, 2,4,5,6-tetrakis(trifluoromethyl)aniline, 2,4-bis(3,5-bis(trifluoromethyl)phenoxy)aniline, and the like.

Further, as other monoamine end capping agents, it is preferable to use a monoamine having a bulky structure (specifically, an alicyclic monoamine) because low dielectric properties tend to be obtained. Specific examples include amines having an adamantyl group such as cyclohexylamine, dicyclohexylamine, methylcyclohexylamine, and adamantaneamine, and amines having a fluorene skeleton.

As the dicarboxylic acid end capping agent, a dicarboxylic acid is preferable, and a part of which may be ring-closed. Examples include phthalic acid, phthalic anhydride, 4-chlorophthalic acid, tetrafluorophthalic acid, 2,3-benzophenonedicarboxylic acid, 3,4-benzophenonedicarboxylic acid, cyclohexane-1,2-dicarboxylic acid, cyclopentane-1,2-dicarboxylic acid, 4-cyclohexene-1,2-dicarboxylic acid, and the like. Among these, phthalic acid and phthalic anhydride are preferred.

Further, as other dicarboxylic acid end capping agents, similar to the other monoamine end capping agents, it is preferable to use a dicarboxylic acid having a halogen element such as fluorine or a dicarboxylic acid having a bulky structure because this can contribute to low dielectric properties.

Only one type of these end capping agents may be used, or two or more types may be used.

The end capping agent is particularly preferably at least one selected from the group consisting of n-octylamine, isooctylamine, 2-ethylhexylamine, n-nonylamine, isononylamine, n-decylamine, and isodecylamine, further preferably at least one selected from the group consisting of n-octylamine, isooctylamine, 2-ethylhexylamine, n-nonylamine, and isononylamine, and still further preferably at least one selected from the group consisting of n-octylamine, isooctylamine, and 2-ethylhexylamine.

The solution (c) containing the polyimide resin precursor containing the polyamic acid includes a solution (a) containing the tetracarboxylic acid component (A) containing a tetracarboxylic dianhydride in the solvent (C) and a solution (b) containing the diamine component (B) containing an aliphatic diamine in the solvent (C). When an end capping agent is used, the solution (c) containing the polyimide resin precursor containing the polyamic acid includes a solution (d) containing the end capping agent in the solvent (C).

In the method for producing the polyimide resin powder of the present invention, from the viewpoint of controlling the solid content concentration of the solution (c) containing the polyimide resin precursor containing the polyamic acid, which is prepared in the above-described step 1, to from 15 to 25% by mass, the content of the tetracarboxylic acid component (A) in the solution (a) is preferably from 20 to 45% by mass, and more preferably from 25 to 45% by mass, and the content of the diamine component (B) in the solution (b) is preferably from 20 to 80% by mass, and more preferably from 40 to 60% by mass.

When an end capping agent is used, the content of the end capping agent in the solution (d) is preferably from 1 to 100% by mass, and more preferably from 10 to 80% by mass.

In the solution (a), the proportion of the tetracarboxylic dianhydride in the tetracarboxylic acid component (A) is preferably 50 mol% or more, more preferably 70 mol% or more, and further preferably 90 mol% or more. It is particularly preferred that the tetracarboxylic acid component (A) consists substantially of the tetracarboxylic dianhydride. As used herein, "substantially" means that when only the tetracarboxylic dianhydride is used as the tetracarboxylic acid component (A), it is permissible for a part thereof (up to about 10 mol%) to have reacted with moisture in the atmosphere and undergone ring opening.

In the above-described step 1, it is preferred to end the addition of the solution (b) to the solution (a) when the total added amount of the diamine component (B) per 1 mol of the tetracarboxylic acid component (A) is 0.9 to 1.1 mol.

When an end capping agent is used, the solution (d) may be added after the solution (b) is added to the solution (a). The type and content of the end capping agent and preferred embodiments thereof are as described above.

The step of reacting the tetracarboxylic acid component (A) and the diamine component (B) in the presence of the solvent (C) can be carried out under normal pressure or under pressure, but it is preferably carried out under normal pressure because a pressureresistant container is not required.

By including the step 1 and the step 2 in the step of reacting the tetracarboxylic acid component (A) and the diamine component (B) in the presence of the solvent (C), the volume average particle size D50 is within a specific range (specifically, from 5 to 50 μm), and a polyimide resin powder having a good particle size distribution can be obtained.

<Polyimide resin powder>

The polyimide resin powder obtained by the production method of the present invention contains a repeating structural unit represented by the following formula (I) and a repeating structural unit represented by the following formula (II), a content ratio of the repeating structural unit of the formula (I) with respect to the total of the repeating structural unit of the formula (I) and the repeating structural unit of the formula (II) being 20 to 70 mol%:

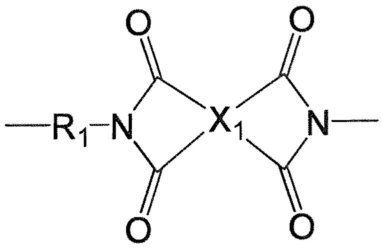

(I)

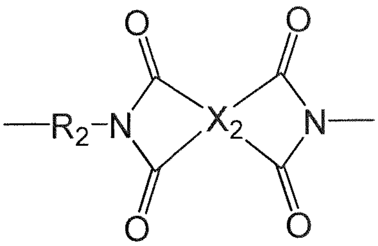

(II)

wherein $R_1$ represents a divalent group having from 6 to 22 carbon atoms containing at least one alicyclic hydrocarbon structure; $R_2$ represents a divalent chain aliphatic group having from 5 to 16 carbon atoms; and $X_1$ and $X_2$ each independently represent a tetravalent group having from 6 to 22 carbon atoms containing at least one aromatic ring.

As measured by a laser diffraction light scattering particle size distribution analyzer, the polyimide resin powder of the present invention has a volume average particle size D50 of preferably from 5 to 50 μm, more preferably from 10 to 40 μm, and further preferably from 13 to 35 μm, a volume average particle size D10 of preferably from 1 to 40 μm, more preferably from 2 to 30 μm, and further preferably from 5 to 25 μm, and a volume average particle size D90 of preferably from 5 to 60 μm, more preferably from 10 to 50 μm, and further preferably from 15 to 45 μm.

There are many benefits to setting the particle size within this range, such as reducing the likelihood of the filter cloth becoming clogged during the production of the polyimide resin powder, improved filtering properties for solvent removal, and a decrease in the residual solution (high-boiling point solvent and moisture) remaining inside the particles.

The volume average particle sizes D50, D10, and D90 can be specifically determined by the method described in the Examples.

The D10 value with respect to the D50 value of the polyimide resin powder, that is, (D10/D50), is preferably 1/3 (0.33) or more, and more preferably 1/2 (0.5) or more.

Further, the D90 value with respect to the D50 value of the polyimide resin powder, that is, (D90/D50), is preferably 3 or less, and more preferably 2 or less.

More preferably, D10/D50 is from 0.45 to 0.9 and D90/D50 is more than 1.4 and 2.0 or less, and further preferably D10/D50 is from 0.7 to 0.9 and D90/D50 is from 1.1 to 1.4.

There are many benefits to setting the particle size distribution in such a range, such as, since a unimodal and sharp shape can be obtained, or since even in the case of a bimodal shape, a sharp main peak can be obtained and the main peak has a large volume frequency, handleability is excellent, for example, productivity improves because

stable feeding can be achieved during extrusion molding, classification can be suppressed during feeding, the fluidity of the powder itself is improved, scattering of fine powder can be suppressed, the filtration and transportation conditions during production of the resin powder are stable, and dispersibility is excellent when used as an additive and so the physical properties tend to be expressed.

The polyimide resin powder is a thermoplastic resin. Thermoplastic polyimide resins are distinguished from, for example, polyimide resins formed by closing the imide ring after shaping in a state of a polyimide precursor such as a polyamic acid and having no glass transition temperature (Tg), or polyimide resins that decompose at a temperature lower than the glass transition temperature.

The repeating structural unit of formula (I) will be described in detail below.

$R_1$ represents a divalent group having from 6 to 22 carbon atoms containing at least one alicyclic hydrocarbon structure. The alicyclic hydrocarbon structure herein means a ring derived from an alicyclic hydrocarbon compound, and the alicyclic hydrocarbon compound may be either saturated or unsaturated and may be either monocyclic or polycyclic.

Examples of the alicyclic hydrocarbon structure include a cycloalkane ring, such as a cyclohexane ring, a cycloalkene ring, such as cyclohexene, a bicycloalkane ring, such as a norbornane ring, and a bicycloalkene ring, such as norbornene, but the alicyclic hydrocarbon structure is not limited thereto. Among these, a cycloalkane ring is preferred, a cycloalkane ring having from 4 to 7 carbon atoms is more preferred, and a cyclohexane ring is further preferred.

$R_1$ has from 6 to 22 carbon atoms, and preferably from 8 to 17 carbon atoms.

$R_1$ contains at least one alicyclic hydrocarbon structure, and preferably from 1 to 3 alicyclic hydrocarbon structures.

$R_1$ is preferably a divalent group represented by the following formula (R1-1) or (R1-2):

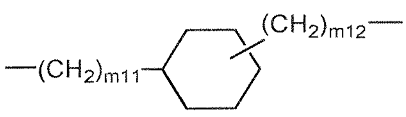

(R1-1)

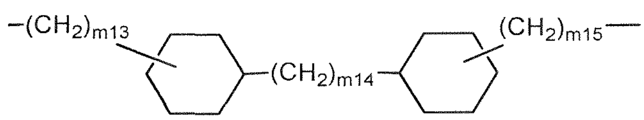

(R1-2)

wherein $m_{11}$ and $m_{12}$ each independently represent an integer of 0-2, and preferably 0 or 1; and $m_{13}$ to $m_{15}$ each independently represent an integer of 0-2, and preferably 0 or 1.

$R_1$ is particularly preferably a divalent group represented by the following formula (RI-3):

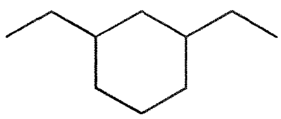

(R1-3)

In the divalent group represented by the formula (R1-3), the conformation of the two methylene groups with respect to the cyclohexane ring may be either cis or trans, and the ratio of cis and trans may be an arbitrary value.

$X_1$ is a tetravalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$X_1$ has from 6 to 22 carbon atoms, and preferably has from 6 to 18 carbon atoms.

$X_1$ contains at least one aromatic ring, and preferably contains from 1 to 3 aromatic rings.

$X_1$ is preferably a tetravalent group represented by one of the following formulae (X-1) to (X-4):

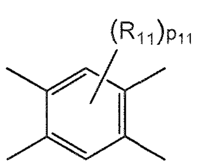

(X-1)

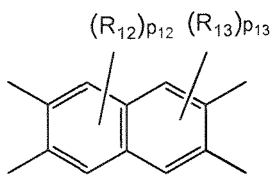

(X-2)

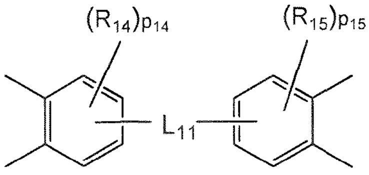

(X-3)

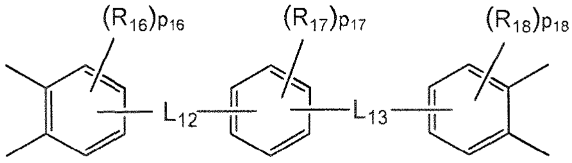

(X-4)

wherein $R_{11}$ to $R_{18}$ each independently represent an alkyl group having from 1 to 4 carbon atoms; $p_{11}$ to $p_{13}$ each independently represent an integer of 0-2, and preferably 0; $p_{14}$, $p_{15}$, $p_{16}$ and $p_{18}$ each independently represent an integer of 0-3, and preferably 0; $p_{17}$ represents an integer of 0-4, and preferably 0; and $L_{11}$ to $L_{13}$ each independently represent a single bond, an ether group, a carbonyl group or an alkylene group having from 1 to 4 carbon atoms.

$X_1$ is a tetravalent group having from 6 to 22 carbon atoms containing at least one aromatic ring, and therefore $R_{12}$, $R_{13}$, $p_{12}$ and $p_{13}$ in the formula (X-2) are selected in such a manner that the tetravalent group represented by the formula (X-2) has from 10 to 22 carbon atoms.

Similarly, $L_{11}$, $R_{14}$, $R_{15}$, $p_{14}$ and $p_{15}$ in the formula (X-3) are selected in such a manner that the tetravalent group represented by the formula (X-3) has from 12 to 22 carbon atoms, and $L_{12}$, $L_{13}$, $R_{16}$, $R_{17}$, $R_{18}$, $p_{16}$, $p_{17}$ and pis in the formula (X-4) are selected in such a manner that the tetravalent group represented by the formula (X-4) has from 18 to 22 carbon atoms.

$X_1$ is particularly preferably a tetravalent group represented by the following formula (X-5) or (X-6):

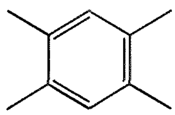

(X-5)

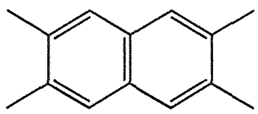

(X-6)

Next, the repeating structural unit of formula (II) will be described in detail below.

$R_2$ represents a divalent chain aliphatic group having from 5 to 16 carbon atoms, preferably from 6 to 14 carbon atoms, more preferably from 7 to 12 carbon atoms, and further preferably from 8 to 10 carbon atoms.

$R_2$ is preferably an alkylene group having from 5 to 16 carbon atoms, more preferably an alkylene group having from 6 to 14 carbon atoms, further preferably an alkylene group having from 7 to 12 carbon atoms, and particularly preferably an alkylene group having from 8 to 10 carbon atoms. The alkylene group may be either a linear alkylene group or a branched alkylene group, and is preferably a linear alkylene group.

$R_2$ preferably represents at least one selected from the group consisting of an octamethylene group and a decamethylene group, and particularly preferably represents an octamethylene group.

Another suitable embodiment of $R_2$ is a divalent chain aliphatic group having from 5 to 16 carbon atoms containing an ether group. The divalent chain aliphatic group preferably has from 6 to 14 carbon atoms, more preferably from 7 to 12 carbon atoms, and further preferably from 8 to 10 carbon atoms. Preferred examples of the group include a divalent group represented by the following formula (R2-1) or (R2-2):

$$-(CH_2)_{m21}-O-(CH_2)_{m22}- \qquad (R2\text{-}1)$$

$$-(CH_2)_{m23}-O-(CH_2)_{m24}-O-(CH_2)_{m25}- \qquad (R2\text{-}2)$$

wherein $m_{21}$ and $m_{22}$ each independently represent an integer of 1-15, preferably 1-13, more preferably 1-11, and further preferably 1-9; and $m_{23}$ to $m_{25}$ each independently represent an integer of 1-14, preferably 1-12, more preferably 1-10, and further preferably 1-8.

$R_2$ represents a divalent chain aliphatic group having from 5 to 16 carbon atoms (preferably from 6 to 14 carbon atoms, more preferably from 7 to 12 carbon atoms, and further preferably from 8 to 10 carbon atoms), and therefore $m_{21}$ and $m_{22}$ in the formula (R2-1) are selected so that the divalent group represented by the formula (R2-1) has from 5 to 16 carbon atoms (preferably from 6 to 14 carbon atoms, more preferably from 7 to 12 carbon atoms, and further preferably from 8 to 10 carbon atoms), i.e., $m_{21} + m_{22}$ is from 5 to 16 (preferably 6 to 14, more preferably 7 to 12, and further preferably 8 to 10).

Similarly, $m_{23}$ to $m_{25}$ in the formula (R2-2) are selected so that the divalent group represented by the formula (R2-2) has from 5 to 16 carbon atoms (preferably from 6 to 14 carbon atoms, more preferably from 7 to 12 carbon atoms, and further preferably from 8 to 10 carbon atoms), i.e., $m_{23} + m_{24} + m_{25}$ is from 5 to 16 (preferably from 6 to 14 carbon atoms, more preferably from 7 to 12 carbon atoms, and further preferably from 8 to 10 carbon atoms).

$X_2$ is defined similarly to $X_1$ in the formula (I), and preferred embodiments thereof are also the same.

The content ratio of the repeating structural unit of the formula (I) with respect to the total of the repeating structural unit of the formula (I) and the repeating structural unit of the formula (II) is 20 mol% to 70 mol%. In the case where the content ratio of the repeating structural unit of the formula (I) is in the above range, the polyimide resin powder may also be sufficiently crystallized in an ordinary injection molding cycle. When the content ratio is less than 20 mol%, molding processability is deteriorated, and when the content ratio is more than 70 mol%, crystallinity is deteriorated to thereby result in deterioration in heat resistance.

The content ratio of the repeating structural unit of the formula (I) with respect to the total of the repeating structural unit of the formula (I) and the repeating structural unit of the formula (II) is preferably 65 mol% or less, more preferably 60 mol% or less, and further preferably 50 mol% or less from the viewpoint of exerting high crystallinity.

Among these, the content ratio of the repeating structural unit of the formula (II) with respect to the total of the repeating structural unit of the formula (I) and the repeating structural unit of the formula (II) is preferably 20 mol% or more and less than 40 mol%. Within this range, the crystallinity of the polyimide resin powder is higher, and thus a resin film can be obtained that has better heat resistance, is more suitable for the production of high-frequency circuit boards (described later), and also has an excellent effect in suppressing the increase in the dielectric loss tangent at high temperatures. In addition, it is generally known that the molecular motion of a resin tends to be more active under high temperatures, and the dielectric properties such as dielectric loss tangent deteriorate, and thus it is considered that imparting crystallinity to the resin and increasing the glass transition temperature of the resin are effective in suppressing the molecular motion of the resin.

The content ratio described above is preferably 25 mol% or more, more preferably 30 mol% or more, further preferably 32 mol% or more from the viewpoint of molding processability, and is still further preferably 35 mol% or less from the viewpoint of exerting high crystallinity.

The content ratio of the total of the repeating structural unit of the formula (I) and the repeating structural unit of the formula (II) with respect to the total repeating structural units constituting the polyimide resin powder is preferably 50 to 100 mol%, more preferably 75 to 100 mol%, further preferably 80 to 100 mol%, and still further preferably 85 to 100 mol%.

The polyimide resin powder may further contain a repeating structural unit represented by the following formula (III). In this case, the content ratio of the repeating structural unit of formula (III) with respect to the total of the repeating structural unit of formula (I) and the repeating structural unit of formula (II) is preferably 25 mol% or less. The lower limit thereof is not particularly limited but needs to exceed 0 mol%.

From the viewpoint of improving heat resistance, the content ratio is preferably 5 mol% or more, and more preferably 10 mol% or more, while from the viewpoint of maintaining crystallinity, the content ratio is preferably 20 mol% or less, and more preferably 15 mol% or less:

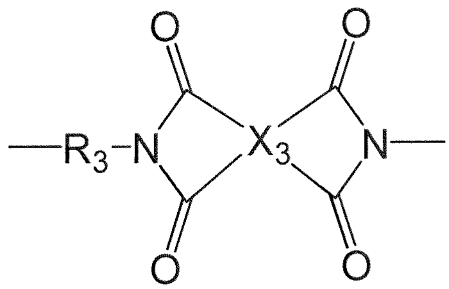

(III)

wherein $R_3$ represents a divalent group having from 6 to 22 carbon atoms containing at least one aromatic ring; and $X_3$ represents a tetravalent group having from 6 to 22 carbon atoms containing at least one aromatic ring.

$R_3$ is a divalent group having from 6 to 22 carbon atoms containing at least one aromatic ring. The aromatic ring may be either a monocyclic ring or a condensed ring, and examples thereof include a benzene ring, a naphthalene ring, an anthracene ring and a tetracene ring, but the aromatic ring is not limited thereto. Among these, a benzene ring and a naphthalene ring are preferred, and a benzene ring is more preferred.

$R_3$ has from 6 to 22 carbon atoms, and preferably has from 6 to 18 carbon atoms.

$R_3$ contains at least one aromatic ring, and preferably contains from 1 to 3 aromatic rings.

The aromatic ring may also be bonded to a monovalent or divalent electron-withdrawing group. Examples of the monovalent electron-withdrawing group include a nitro group, a cyano group, a p-toluenesulfonyl group, a halogen, an alkyl halide group, a phenyl group, an acyl group, and the like. Examples of the divalent electron-withdrawing group include alkylene halide groups such as alkylene fluoride groups (e.g., $-C(CF_3)_2-$ and - $(CF_2)_p-$ (wherein p is an integer of 1-10)), as well as -CO-, $-SO_2-$, -SO-, -CONH-, -COO-, and the like.

$R_3$ is preferably a divalent group represented by the following formula (R3-1) or (R3-2):

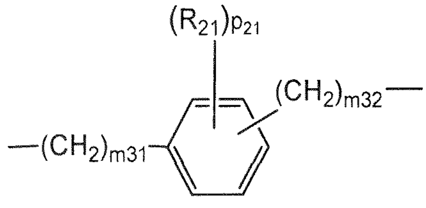

(R3-1)

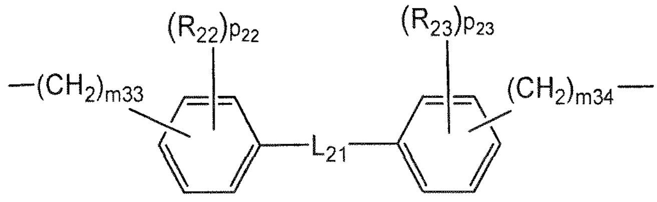

(R3-2)

wherein $m_{31}$ and $m_{32}$ each independently represent an integer of 0-2, and preferably 0 or 1; $m_{33}$ and $m_{34}$ each independently represent an integer of 0-2, and preferably 0 or 1; $R_{21}$, $R_{22}$ and $R_{23}$ each independently represent an alkyl group having from 1 to 4 carbon atoms, an alkenyl group having from 2 to 4 carbon atoms or an alkynyl group having from 2 to 4 carbon atoms, $p_{21}$, $p_{22}$ and $p_{23}$ each represent an integer of 0-4, and preferably 0; and $L_{21}$ represents a single bond, an ether group, a carbonyl group or an alkylene group having from 1 to 4 carbon atoms.

$R_3$ is a divalent group having from 6 to 22 carbon atoms containing at least one aromatic ring, and therefore $m_{31}$, $m_{32}$, $R_{21}$ and $p_{21}$ in the formula (R3-1) are selected in such a manner that the divalent group represented by the formula (R3-1) has from 6 to 22 carbon atoms.

Similarly, $L_{21}$, $m_{33}$, $m_{34}$, $R_{22}$, $R_{23}$, $p_{22}$ and $p_{23}$ in the formula (R3-2) are selected in such a manner that the divalent group represented by the formula (R3-2) has from 12 to 22 carbon atoms.

$X_3$ is defined similarly to $X_1$ in the formula (I), and preferred embodiments thereof are also the same.

The polyimide resin powder may further contain a repeating structural unit represented by the following formula (IV):

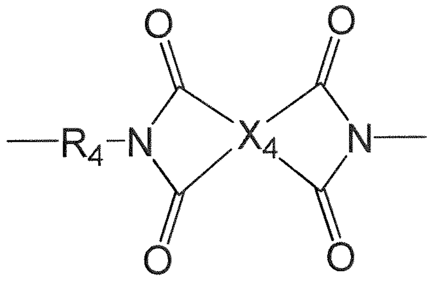

(IV)

wherein $R_4$ represents a divalent group containing $-SO_2-$ or $-Si(R_x)(R_y)O-$; $R_x$ and $R_y$ each independently represent a chain aliphatic group having from 1 to 3 carbon atoms, or a phenyl group; and $X_4$ represents a tetravalent group having from 6 to 22 carbon atoms containing at least one aromatic ring.

$X_4$ is defined similarly to $X_1$ in the formula (I), and preferred embodiments thereof are also the same.

The end structure of the polyimide resin powder is not particularly limited, and preferably has a chain aliphatic group having 5 to 14 carbon atoms at the end thereof.

The chain aliphatic group may be either saturated or unsaturated, and may be in the form of either linear or branched chain. When the polyimide resin powder contains the above particular group at the end thereof, it is possible to obtain a resin film excellent in heat aging resistance.

Example of the saturated chain aliphatic group having from 5 to 14 carbon atoms include an n-pentyl group, an n-hexyl group, an n-heptyl group, an n-octyl group, an n-nonyl group, an n-decyl group, an n-undecyl group, a lauryl

group, an n-tridecyl group, an n-tetradecyl group, an isopentyl group, a neopentyl group, a 2-methylpentyl group, a 2-methylhexyl group, a 2-ethylpentyl group, a 3-ethylpentyl group, an isooctyl group, a 2-ethylhexyl group, a 3-ethylhexyl group, an isononyl group, a 2-ethyloctyl group, an isodecyl group, an isododecyl group, an isotridecyl group and an isotetradecyl group.

Example of the unsaturated chain aliphatic group having from 5 to 14 carbon atoms include a 1-pentenyl group, a 2-pentenyl group, a 1-hexenyl group, a 2-hexenyl group, a 1-heptenyl group, a 2-heptenyl group, a 1-octenyl group, a 2-octenyl group, a nonenyl group, a decenyl group, a dodecenyl group, a tridecenyl group and a tetradecenyl group.

Among these, the chain aliphatic group is preferably a saturated chain aliphatic group, and more preferably a saturated linear aliphatic group. The chain aliphatic group preferably has 6 or more carbon atoms, more preferably 7 or more carbon atoms and further preferably 8 or more carbon atoms, and preferably has 12 or less carbon atoms, more preferably 10 or less carbon atoms and further preferably 9 or less carbon atoms from the viewpoint of achievement of heat aging resistance. The chain aliphatic group may be adopted singly or in combinations of two or more.

The chain aliphatic group is particularly preferably at least one selected from the group consisting of an n-octyl group, an isooctyl group, a 2-ethylhexyl group, an n-nonyl group, an isononyl group, an n-decyl group and an isodecyl group, further preferably at least one selected from the group consisting of an n-octyl group, an isooctyl group, a 2-ethylhexyl group, an n-nonyl group, and an isononyl group, and most preferably at least one selected from the group consisting of an n-octyl group, an isooctyl group, and a 2-ethylhexyl group.

The polyimide resin powder preferably contains only a chain aliphatic group having from 5 to 14 carbon atoms, besides a terminal amino group and a terminal carboxy group, at the end thereof from the viewpoint of heat aging resistance. When a group, besides the above groups, is contained at the end, the content thereof with respect to the chain aliphatic group having from 5 to 14 carbon atoms is preferably 10 mol% or less and more preferably 5 mol% or less.

The content of the chain aliphatic group having from 5 to 14 carbon atoms in the polyimide resin powder is preferably 0.01 mol% or more, more preferably 0.1 mol% or more, and further preferably 0.2 mol% or more based on the total 100 mol% of the total repeating structural units constituting the polyimide resin powder from the viewpoint of exerting excellent heat aging resistance. Further, to ensure a sufficient molecular weight and obtain good mechanical properties, the content of the chain aliphatic group having from 5 to 14 carbon atoms in the polyimide resin powder is, with respect to a total of 100 mol% of all the repeating structural units constituting the polyimide resin powder, preferably 10 mol% or less, more preferably 6 mol% or less, and further preferably 3.5 mol% or less.

The content of the chain aliphatic group having from 5 to 14 carbon atoms in the polyimide resin powder can be determined by depolymerization of the polyimide resin powder.

The polyimide resin powder preferably has a melting point of 360°C or lower and a glass transition temperature of 150°C or higher. The melting point of the polyimide resin powder is more preferably 280°C or higher and further preferably 290°C or higher from the viewpoint of heat resistance, and is preferably 345°C or lower, more preferably 340°C or lower, and further preferably 335°C or lower from the viewpoint of exerting high molding processability. In addition, the glass transition temperature of the polyimide resin powder is more preferably 160°C or higher and more preferably 170°C or higher from the viewpoint of heat resistance, and is preferably 250°C or lower, more preferably 230°C or lower, and further preferably 200°C or lower from the viewpoint of exerting high molding processability.

The melting point and glass transition temperature of the polyimide resin powder can all be measured by a differential scanning calorimeter.

In addition, in the polyimide resin powder, the exothermic amount (hereinafter, also simply referred to as "exothermic amount of crystallization") of the crystallization exothermic peak observed in melting and then cooling of the polyimide resin powder at a cooling rate of 20°C/min with differential scanning calorimetric measurement is preferably 5.0 mJ/mg or more, more preferably 10.0 mJ/mg or more, and further preferably 17.0 mJ/mg or more from the viewpoint of enhancement of crystallinity, heat resistance, mechanical strength, and chemical resistance. The upper limit of the exothermic amount of crystallization is not particularly limited, and is usually 45.0 mJ/mg or less.

The melting point, glass transition temperature, and exothermic amount of crystallization of the polyimide resin powder specifically can be measured by the methods described in the examples.

The logarithmic viscosity of the polyimide resin powder at 30°C in a 0.5 mass% concentrated sulfuric acid solution is preferably in the range of 0.2 to 2.0 dL/g and more preferably 0.3 to 1.8 dL/g. When the logarithmic viscosity is 0.2 dL/g or more, a formed article formed of the polyimide resin powder obtained has sufficient mechanical strength, and when the logarithmic viscosity is 2.0 dL/g or less, formability and handleability are good. The logarithmic viscosity μ is obtained according to the following expression by measuring the elapsed times for flowing concentrated sulfuric acid and the polyimide resin solution at 30°C with a Cannon-Fenske viscometer.

$$\mu = \ln(ts/t_0)/C$$

$t_0$: elapsed time for flowing concentrated sulfuric acid

ts: elapsed time for flowing polyimide resin solution
C: 0.5 (g/dL)

The weight average molecular weight Mw of the polyimide resin powder is preferably in the range of 10,000 to 150,000, more preferably 15,000 to 100,000, further preferably 20,000 to 80,000, still further preferably 30,000 to 70,000, and still further preferably 35,000 to 65,000. Further, if the weight average molecular weight Mw of the polyimide resin powder is 10,000 or more, the mechanical strength of the obtained formed article is good, and if Mw is 40,000 or more, the stability of the mechanical strength is good, and if Mw is 150,000 or less, the molding processability is good.
The weight average molecular weight Mw of the polyimide resin powder can be measured by a gel permeation chromatography (GPC) method using polymethyl methacrylate (PMMA) as a standard sample.

<Resin film>

The present invention provides a film-like formed article (resin film) obtained using a forming material containing a polyimide resin powder having a specific composition obtained by the production method of the present invention.
The resin film of the present invention is obtained using a forming material containing a polyimide resin powder having a specific composition obtained by the production method of the present invention. Although the mechanism by which the effect of suppressing the increase in the dielectric loss tangent at high temperatures is exhibited is not necessarily clear, it is considered to be as follows.
The polyimide resin powder obtained by the production method of the present invention contains, as a divalent group derived from the diamine component (B), a divalent group having from 6 to 22 carbon atoms containing at least one alicyclic hydrocarbon structure and a divalent chain aliphatic group having from 5 to 16 carbon atoms in a specific proportion.
Since the alicyclic hydrocarbon structure has a bulky structure, it is thought that the alicyclic hydrocarbon structure tends to cause the free volume of the resin (the difference between the volume actually occupied by the substance and the space occupied volume calculated from the atomic radius etc.) to increase. This is considered to be one of the reasons why an effect of an improvement in the dielectric properties such as the dielectric loss tangent is exhibited. Among such alicyclic hydrocarbon structures, a divalent group derived from an alicyclic diamine with low symmetry (e.g., 1,3-bis(aminomethyl)cyclohexane), is thought to tend to increase the free volume of the resin by a larger amount, and thus it is considered that the effect of an improvement in the dielectric properties such as the dielectric loss tangent is increased.
In addition to this room-temperature design concept, the polyimide resin powder having the specific composition range of the present invention also has a design concept that enables a high crystallization temperature to be exhibited in the crystallized portion and a high glass transition temperature to be exhibited in the amorphous portion.
Therefore, it can be considered that a resin film obtained using a forming material containing the polyimide resin powder of the present invention, which has a not only has a design concept at room temperature but also at high temperatures, is less susceptible to active molecular motion of the resin even at high temperatures and can suppress deterioration of the dielectric properties such as the dielectric loss tangent.
It is known that crystalline resins tend to, in general, reduce the water absorption rate. From this, it is considered that the resin film of the present invention also exhibits an effect of suppressing a deterioration in the dielectric properties such as the dielectric loss tangent due to the influence of water absorption under high humidity.
A ratio of a dielectric constant $P_{40}$ at 40°C and a dielectric constant $P_{120}$ at 120°C, $P_{120}/P_{40}$, of the resin film at 10 GHz is preferably from 0.8 to 1.2, and more preferably from 0.8 to 1.1.
A ratio of a dielectric constant $P_{40}$ at 40°C and a dielectric constant $P_{120}$ at 120°C, $P_{120}/P_{40}$, of the resin film at 20 GHz is preferably from 0.8 to 1.2, and more preferably from 0.85 to 1.1.
A ratio of a dielectric loss tangent $Q_{40}$ at 40°C and a dielectric loss tangent $Q_{120}$ at 120°C, $Q_{120}/Q_{40}$, of the resin film at 10 GHz is preferably from 1.0 to 1.5, and more preferably from 1.0 to 1.3.
A ratio of a dielectric loss tangent $Q_{40}$ at 40°C and a dielectric loss tangent $Q_{120}$ at 120°C, $Q_{120}/Q_{40}$, of the resin film at 20 GHz is preferably from 1.0 to 1.7, and more preferably from 1.2 to 1.6.
The dielectric constant and dielectric loss tangent of the resin film can be specifically measured by the methods described in the Examples.
The saturated water absorption of the resin film is 1.0% or less, preferably 0.9% or less, and more preferably 0.8% or less under conditions of 85°C and 85% relative humidity.
Specifically, the saturated water absorption rate of the resin film can be measured by the method described in the Examples.
For the forming material of the resin film, additives other than the polyimide resin powder can be added as necessary within a range in which the properties of the polyimide resin powder are not impaired.
Examples of additives include delusterants, plasticizers, antistatic agents, anti-coloring agents, anti-gelling

agents, colorants, antioxidants, conducting agents, resin-modifying agents, flame retardants, glass fibers, carbon fibers, crystal nucleating agents, crystallization retarding agents, slidability improvers, low dielectric constant agents such as fluororesin powders and calcium carbonate powders.

NE glass, which has low dielectric properties, is suitably used as the glass fiber. As the flame retardant, from the viewpoint of improving the appearance of the formed product, it is suitable to use a flame retardant having a melting point or a glass transition temperature, or a fine powder flame retardant having a size of several microns or less. As the fluororesin, it is suitable to use a fine powder fluororesin having a size of several microns or less.

The amount of the additive added is not particularly limited, but from the viewpoint that the effect of the additive is exerted while maintaining the physical properties derived from the polyimide resin powder, the content in the forming material is usually 50% by mass or less, preferably from 0.0001 to 30% by mass, more preferably from 0.001 to 15% by mass, and further preferably from 0.01 to 10% by mass.

Further, as the forming material of the resin film, other resins than the polyimide resin powder can be added as long as the properties of the polyimide resin powder are not impaired.

The other resin is preferably a high heat-resistance thermoplastic resin. Examples thereof include a polyamide resin, a polyester resin, a polyimide resin other than the aforementioned polyimide resin powder, a polycarbonate resin, a polyether imide resin, a polyamide imide resin, a polyphenylene ether imide resin, a polyphenylene sulfide resin, a polysulfone resin, a polyether sulfone resin, a polyarylate resin, a liquid crystal polymer, a polyether ketone resin (polyether ether ketone resin, polyether ketone resin, polyether ketone ketone resin, polyether ether ketone ketone resin, etc.), a polybenzimidazole resin, a fluororesin, and the like. Among these, from the viewpoint of heat resistance (heat aging resistance, short-term heat resistance, retention of physical properties at high temperatures, etc.), formability, strength, excellent dielectric properties at high temperatures, and solvent resistance, at least one selected from the group consisting of a polyether imide resin, a polyphenylene sulfide resin, and a polyether ketone resin is preferred.

When the polyimide resin powder is used together with another resin, there are no particular restrictions on the mixing ratio as long as the properties of the polyimide resin powder are not impaired. Specifically, the mixing ratio can be freely selected in the range of 1/99 to 99/1 in accordance with the various required properties.

However, from the viewpoint of obtaining the effect of suppressing the increase in the dielectric loss tangent at high temperatures, the content of the polyimide resin powder in the forming material used for producing the resin film is preferably 20% by mass or more, more preferably 45% by mass or more, further preferably 70 mass % or more, and still further preferably 80 mass % or more. The upper limit is 100% by mass.

The above forming material may be used in powder form for the forming of the resin film and the like, or may be pelletized and then used for the forming of the resin film and the like.

Since the polyimide resin powder of the present invention is thermoplastic, a film-like formed article (resin film) can be easily produced by thermoforming.

Examples of the method for obtaining the film-like formed article (resin film) include (i) obtaining the film-like formed article by feeding a forming material containing the polyimide resin powder into an extruder, directly extruding, and then performing various kinds of thermoforming, (ii) obtaining the film-like formed article by feeding a forming material containing the polyimide resin powder into an extruder, pelletizing, and then performing various kinds of thermoforming using the pellets, and (iii) obtaining the film-like formed article by direct compression-molding of a forming material containing the polyimide resin powder with a hot press apparatus.

The method for producing the resin film preferably has a step of thermoforming a forming material containing the polyimide resin powder and various optional components as necessary at from 300 to 410°C. As a specific procedure, for example, in the case of the above method (ii), the following method can be mentioned.

First, the polyimide resin powder and various optional components as necessary are dry blended, then charged into an extruder, melted at a temperature of preferably from 300 to 410°C, and melt-kneaded in the extruder and extruded to produce pellets.

Alternatively, the polyimide resin powder fed into an extruder, melted at a temperature of preferably from 300 to 410°C, various optional components as necessary are fed into the extruder, and melt-kneaded in the extruder and extruded to produce the pellets.

A film-like formed article (resin film) can be obtained by drying the produced pellets, then feeding into a single-screw extruder or a twin-screw extruder equipped with a T-die and melt-kneading at a temperature of preferably from 300 to 410°C, continuously extruding the melt-kneaded forming material from various dies such as a T-die of a single-screw extruder or a twin-screw extruder, and then cooling with a metal roll, which is a cooling roll having a temperature of preferably 100 to 250°C. After the film-like formed article is obtained, it is also possible carry out various stretching processes in-line or off-line. As the stretching conditions in the stretching step, the film-like formed article can be preheated in a temperature range of preferably 100 to 300°C, and stretched preferably 1.1 times or more, more preferably 1.5 times or more, in each of the MD and TD directions. By stretching the film, the mechanical strength of the film itself can be improved, and the linear expansion coefficient in the stretching direction can be significantly reduced, so it is particularly suitable for multilayer applications with a low linear expansion coefficient material.

The resin film of the present invention also encompasses a plate-like or sheet-like film having a thickness of 5 mm or less.

The resin film may have any thickness in accordance with the application, and is not particularly limited as long as it is from 2 to 1000 μm. When the resin film is applied to a high-frequency circuit board, from the viewpoint of handleability and thinness, the thickness of the resin film is preferably from 5 to 800 μm, more preferably from 10 to 500 μm, and further preferably from 12.5 μm to 250 μm.

From the viewpoint of suppressing deformation during heating and cooling when forming a copper clad laminate, which will be described later, the linear expansion coefficient in the plane directions (X direction, Y direction) of the resin film of the present invention is, in the temperature range of from 50°C to at or below the glass transition temperature of the resin film, preferably 80 ppm or less, more preferably 50 ppm or less, and further preferably 20 ppm or less. In addition, from the viewpoint of suppressing deformation in the lamination direction when the resin film is highly multilayered, the linear expansion coefficient in the thickness direction (Z direction) of the resin film is, in the temperature range of from 50°C to at or below the glass transition temperature of the resin film, preferably 300 ppm or less, more preferably 200 ppm or less, and further preferably 100 ppm or less. Since the resin film of the present invention is crystalline, the resin film is easily stacked in the thickness direction and also has a high glass transition temperature. As a result, in particular, it is expected that the linear expansion coefficient in the thickness direction can be reduced.

According to the resin film of the present invention, since it is possible to suppress the increase in dielectric loss tangent at high temperatures, for example, the resin film can be applied to, for example, a high-frequency circuit board, a copper clad laminate (CCL), in particular a copper clad laminate that uses a low-roughness (arithmetic average roughness Ra = 1 μm or less) copper foil, a bonding sheet, a film condenser, a printed circuit board, a transmission lines such as a coaxial line, a strip line, a microstrip line, a coplanar line, and a parallel line, a microwave antenna, a millimeter wave antenna, a waveguide slot antenna, a horn antenna, a lens antenna, a printed antenna, a triplate antenna, a microstrip antenna, a patch antenna, various sensors, an automotive radar, an aerospace radar, a semiconductor device material, a coating for a bearing, a heat insulating shaft, a tray, various belts such as a seamless belt, a heat-resistant low-dielectric tape, a heat-resistant low-dielectric tube, a low-dielectric wire coating material, a radome (radar dome), a 5G smartphone/5G terminal antenna board, a 6G smartphone/6G terminal antenna board, a chip-on-film (COF) flexible board, an optical communication module (TOSA/ROSA), a 77 GHz in-vehicle millimeter wave radar antenna board, a terahertz wave radar antenna board, an aircraft radar antenna board, a tracked vehicle antenna board, an 8K-TV cable, a WiGig antenna board, a tablet terminal, a laptop PC, a flat-screen TV, a roll-up TV, a mobile terminal or digital home appliance such as a digital camera, a macro cell base station, a small cell base station, a C-RAN base station, a commercial drone, a long-distance mobile drone, a surveillance camera, smart glasses, a smart watch, a wafers for a high-frequency device, a wireless communication device, a Wi-Fi chip, a touch sensor, an indoor server, an outdoor server, an industrial robot board, a home robot communication board, an artificial satellite, a space station communication device, and the like. Among these, because the resin film of the present invention can suppress the increase in dielectric loss tangent at high temperatures, the resin film is suitable for high-frequency circuit boards and copper clad laminates.

In addition, examples of applications that the powder can be used in as is include a starting material for dry blending, a starting material for compression molded products such as a packing and an IC inspection jig, a toughness imparting agent for CFRP, a toughness imparting agent for thermosetting resins and thermoplastic resins, a heat resistance improving agent, a coating material, a lubricant, a starting material for a 3D printer, a starting material for a UD tape, and the like.

<High-frequency circuit board>

The present invention provides a high-frequency circuit board including the resin film of the present invention.

The high-frequency circuit board of the present invention may have any layer other than the resin film, but from the viewpoint of suppressing the increase in the dielectric loss tangent at high temperatures, the high-frequency circuit board is preferably composed only of the resin film. In that case, the resin composition constituting the high-frequency circuit board, the method for producing the high-frequency circuit board, the dielectric properties (dielectric constant and dielectric loss tangent), the saturated water absorption rate, and the preferred embodiments thereof are as described for the resin film.

The thickness of the high-frequency circuit board is preferably from 5 to 800 μm, more preferably from 10 to 500 μm, and further preferably from 12.5 to 250 μm, from the viewpoint of ensuring strength and dielectric properties.

<Copper clad laminate>

The present invention also provides a copper clad laminate including a layer composed of the resin film of the present invention.

It is sufficient that the copper clad laminate of the present invention have a layer composed of the resin film of the present invention (hereinafter, also simply referred to as "resin film layer") and at least one copper foil layer. For example, the copper clad laminate may be a laminate having a structure in which a copper foil layer is laminated on at least one surface, preferably both surfaces, of the resin film layer. A copper clad laminate having such a structure can be obtained, for example, by bonding together the resin film of the present invention and the copper foil by a known method.

The resin film used in the production of the copper clad laminate can be produced by the same method as described above. From the viewpoint of ensuring the strength of the copper clad laminate and improving the adhesiveness between the resin film layer and the copper foil layer, the thickness of the resin film and the resin film layer in the copper clad laminate is preferably from 5 to 500 μm, more preferably 10 to 300 μm, and further preferably from 12.5 to 200 μm.

The copper foil used in the production of the copper clad laminate is not particularly limited, and commercially available rolled copper foil, electrolytic copper foil, and the like can be used, but from the viewpoint of flexibility, rolled copper foil is more suitable. From the viewpoint of ensuring sufficient conductivity and improving adhesiveness with the resin film layer, the thickness of the copper foil layer and the copper foil used for the formation thereof is preferably from 2 to 50 μm, more preferably from 3 to 30 μm, and further preferably from 5 to 20 μm. The thickness is the thickness per copper foil layer or per copper foil.

The surface roughness of the copper foil used in the production of the copper clad laminate is not particularly limited, but the surface roughness of the copper foil is directly linked to the electrical properties of the laminate itself that is obtained after bonding the resin film, and generally the lower the roughness, the better the dielectric properties of the laminate. Therefore, a maximum height Rz of the copper foil surface is preferably in the range of 0.1 to 1 μm, and more preferably in the range of 0.2 to 0.8 μm. The maximum height Rz of the copper foil surface can be measured, for example, with a surface roughness meter.

From the viewpoint of improving the strength and conductivity of the copper clad laminate, the thickness of the copper clad laminate is preferably from 15 to 600 μm, more preferably from 25 to 500 μm, and further preferably from 50 to 300 μm. The copper clad laminate may have any layer other than the resin film layer and the copper foil layer as long as the effects of the present invention are not impaired.

The method for producing the copper clad laminate is not particularly limited, and examples include a method of stacking the resin film of the present invention and the copper foil, and then bonding them together under heating and pressure conditions by a known method. Since the resin film of the present invention contains a thermoplastic polyimide resin, the resin film can be bonded to the copper foil by melting the surface of the resin film and crimping together in that state.

Any apparatus can be used for the production of the copper clad laminate as long as the apparatus is capable of bonding the resin film and the copper foil under heat and pressure conditions, and examples include a roll laminator, a flat plate laminator, a double belt press machine, and the like. Among these, it is preferable to use a double belt press machine from the viewpoint of the productivity of the copper clad laminate and the viewpoint of obtaining a copper clad laminate with a good appearance. The double belt press machine is equipped with an endless belt arranged in a pair of upper and lower parts, and is an apparatus that can produce the laminate by continuously feeding the film-shaped materials (resin film and copper foil) for forming each layer onto the belt, and heating and pressing the materials by a heating and pressing mechanism via the endless belt.

Examples of the double belt press machine include the apparatus described in JP 2010-221694 A, and the double belt press machine produced by Dymco, Ltd.

The heating temperature for producing the copper clad laminate by the above method is not particularly limited as long as the method can soften or melt the resin film, but from the viewpoint of reducing the equipment load and the production load, the heating temperature is preferably in the range of 250 to 400°C, and more preferably in the range of 280 to 350°C. In addition, from the viewpoint of improving the adhesiveness between the resin film and the copper foil, reducing the equipment load, and reducing the production load, the pressure conditions when producing the copper clad laminate are preferably from 0.1 to 20 MPa, more preferably from 0.15 to 15 MPa, and further preferably from 0.2 to 12 MPa. Further, from the viewpoint of improving production efficiency, the pressurization time is preferably in the range of 1 to 600 seconds, more preferably 5 to 400 seconds, and further preferably 10 to 300 seconds.

The resin film according to the present invention is characterized by being heatsealable, but in the production of the copper clad laminate, it is also possible to bond the resin film and the copper foil by using an adhesive. As the adhesive, a varnish-like adhesive, a sheet-like adhesive, a powder-like adhesive, or the like can be freely selected. On the other hand, from the viewpoint of ensuring low dielectric properties, it is preferable that the adhesive also have low dielectric properties. Examples of adhesives having low dielectric properties include the polyimide adhesive "PIAD" series produced by Arakawa Chemical Industries, Ltd.

## Examples

The present invention will be described in more detail with reference to examples below, but the present

invention is not limited thereto. Further, various measurements and evaluations in each of the Production Examples, Examples and Comparative Examples were carried out in the following manner.

(1) Physical properties of the polyimide resin powder

(1-1) Infrared spectroscopy (IR measurement)

The IR measurement of the polyimide resin powder produced in each of the examples was performed with "JIR-WINSPEC 50", produced by JEOL, Ltd.

(1-2) Logarithmic viscosity $\mu$

The polyimide resin powder produced in each of the examples was dried at from 190 to 200°C for 2 hours, and then 0.100 g of the polyimide resin powder was dissolved in 20 mL of concentrated sulfuric acid (96%, produced by Kanto Chemical Co., Inc.) to form a polyimide resin solution, and the measurement was made at 30°C with a Cannon-Fenske viscometer using the polyimide resin solution as a measurement sample. The logarithmic viscosity $\mu$ was obtained according to the following expression.

$$\mu = \ln(ts/t_0)/C$$

$t_0$: elapsed time for flowing concentrated sulfuric acid
ts: elapsed time for flowing polyimide resin solution
C: 0.5 g/dL

(1-3) Melting point, glass transition temperature, crystallization temperature, and exothermic amount of crystallization

The melting point Tm, glass transition temperature Tg, crystallization temperature Tc and the exothermic amount of crystallization $\Delta$Hm of the polyimide resin powder produced in each of the examples were measured with a differential scanning calorimeter ("DSC-6220", produced by SII Nanotechnology, Inc.).

In a nitrogen atmosphere, a thermal history of the following conditions was imposed on the polyimide resin powder. The condition of the thermal history included the first heating (heating rate: 10°C/min), then cooling (cooling rate: 20 °C/min), and then second heating (heating rate: 10°C/min).

The melting point Tm was determined by reading the peak top value of the endothermic peak observed in the second heating. The glass transition temperature (Tg) was determined by reading the value observed in the second heating. The crystallization temperature (Tc) was determined by reading the peak top value of the exothermic peak observed in cooling.

The exothermic amount of crystallization $\Delta$Hm (mJ/mg) was calculated from the area of the exothermic peak observed in cooling.

(1-4) Crystallization half-time

The crystallization half-time of the polyimide resin powder produced in each of the examples was measured with a differential scanning calorimeter ("DSC-6220", produced by SII Nanotechnology, Inc.).

The measurement conditions of a polyimide resin having a semi-crystallization time of 20 seconds or less was determined as the following: the polyimide resin was held at 420°C for 10 minutes in a nitrogen atmosphere so as to completely melt, then quenched at a cooling rate of 70°C/min, and the time required from the appearance of the observed crystallization peak to the peak top thereof was calculated.

(1-5) Weight average molecular weight

The weight average molecular weight (Mw) of the polyimide resin powder produced in each of the examples was measured with a gel permeation chromatography (GPC) measurement apparatus "Shodex GPC-101" produced by Showa Denko K.K. under the following conditions.

Column: Shodex HFIP-806M
Mobile phase solvent: HFIP containing 2 mM sodium trifluoroacetate
Column temperature: 40°C

Flow rate of mobile phase: 1.0 mL/min
Specimen concentration: about 0.1 mass%
Detector: IR detector
Amount of injection: 100 μm
Calibration curve: standard PMMA

(1-6) Volume average particle size (D10, D50, D90)

The D10, D50, and D90 of the polyimide resin powder produced in each example were obtained from the results of laser diffraction particle size distribution measurement. The results of the particle size distribution measurement of the polyimide resin powder produced in each example are shown in Figs. 1 to 10.

A laser diffraction light scattering particle size distribution analyzer "LMS-2000e" produced by Malvern Panalytical Ltd was used as the measurement equipment. The D10, D50, and D90 measurements of the polyimide resin powder were carried out using water as a dispersion medium under ultrasonic conditions so that the polyimide resin powder was sufficiently dispersed. The measurement range was 0.02 to 2000 μm.

(2) Physical properties of resin film

(2-1) Saturated water absorption

Using the polyimide resin powder produced in Example 1, a resin film was produced by the method described later, and cut into 10 pieces having a size of 10 mm x 10 mm x 50 μm in thickness. These pieces were used as the test pieces for one test.

In accordance with JIS K7209: 2000, the test pieces were dried at 50°C for 24 hours, then returned to room temperature in a desiccator, and a weight (W0) was measured under an environment of a temperature of 23°C and a relative humidity of 50%. Subsequently, the film was placed in a water desorption device IGA SORP (produced by Hiden Isochema Ltd), and the environment was set to a temperature of 85°C and a relative humidity of 85%. A weight (W1) was measured when the sample weight became stable. The saturated water absorption was calculated based on the following formula.

$$\text{Saturated water absorption (\%)} = [(W1-W0)/W0] \times 100$$

(2-2) Dielectric properties

Using the polyimide resin powder produced in Example 1, a resin film was produced by the method described later, and cut into test pieces having a size of 60 mm x 75 mm x 50 μm in thickness.

The test pieces were dried in a desiccator, and then immediately used for measurement. As the measurement equipment, a network analyzer P5007A (produced by Keysight Technologies), a split cylinder resonator 20 GHz CR-720 (produced by EM Labs), split cylinder temperature special evaluation software CR-TC (produced by EM Labs), and an environmental test device SH-662 (produced by ESPEC Corp.) were used. The dielectric constant and the dielectric loss tangent at frequencies of 10 GHz and 20 GHz were measured in an environment of from -40 to 150°C by the cavity resonator perturbation method in accordance with IEC 62810. The measurement value was the average value of n=2.

[Example 1]

<Production of polyimide resin powder>

800 g of 2-(2-methoxyethoxy)ethanol (produced by Nippon Nyukazai Co., Ltd.) and 191.95 g (0.88 mol) of pyromellitic dianhydride (produced by Lonza K.K.) were introduced in a 2 L separable flask equipped with a Dean-Stark apparatus, a Liebig condenser tube, a thermocouple, and a four-paddle blade. After creation of a nitrogen flow, the mixture was agitated at 150 rpm so as to become a homogeneous suspended solution. On the other hand, 43.81 g (0.308 mol) of 1,3-bis(aminomethyl)cyclohexane (produced by Mitsubishi Gas Chemical Company, Inc., cis/trans ratio = 7/3) and 82.52 g (0.572 mol) of 1,8-octamethylenediamine (produced by Kanto Chemical Co., Inc.) were dissolved in 250 g of 2-(2-methoxyethoxy)ethanol with a 500 mL beaker, thereby preparing a mixed diamine solution.

This mixed diamine solution was added dropwise to the suspended solution in the 2 L separable flask over 60 minutes using a plunger pump. Heat was generated due to the dropwise addition, but the internal temperature was adjusted to be within the range of 40 to 80°C. The dropwise addition of the mixed diamine solution was carried out in a

nitrogen flow state over the whole period. The number of rotations of the agitation blade was set to 250 rpm. Further, the peak exothermic temperature during the dropwise addition was 65°C. After the completion of the dropwise addition, 130 g of 2-(2-methoxyethoxy)ethanol and 1.13 g (0.0088 mol) of n-octylamine (produced by Kanto Chemical Co., Inc.) as an end capping agent were added thereto, and the mixture was further agitated. At this stage, a pale yellow polyamic acid solution (c) having a solid content concentration of 20% by mass was obtained. Next, the agitation speed was set to 200 rpm, and the polyamic acid solution (c) in the 2 L separable flask was then heated to 190°C. In this heating process, the heating was carried out by setting the average heating rate when the solution temperature was in the range of 70 to 130°C to 0.91 °C/min. The deposition of a polyimide resin powder and dehydration associated with imidization were confirmed in this temperature range. When the solution temperature exceeded 130°C, the heating of the solution was continued at an average heating rate same as the average heating rate in the range of 70 to 130°C, the solution was kept at 190°C for 30 minutes, then allowed to cool to room temperature, and filtered. The obtained polyimide resin powder was washed and filtered with 300 g of 2-(2-methoxyethoxy)ethanol and 300 g of methanol, and then dried in a dryer at 180°C for 10 hours to obtain 317 g of a polyimide resin powder.

The measurement of the IR spectrum of polyimide resin powder showed the characteristic absorption of an imide ring ν(C=O) observed at 1768 and 1697 ($cm^{-1}$).

When the physical properties of the polyimide resin powder were measured, the logarithmic viscosity was 1.60 dL/g, Tm was 323°C, Tg was 184°C, Tc was 266°C, the heat of crystallization was 21.0 mJ/mg, the half-crystallization time was 20 seconds or less, and Mw was 55,000.

Table 1 shows the composition and evaluation results of the polyimide resin powder of Example 1. The values expressed in mol% of the tetracarboxylic acid component and the diamine component in Table 1 are values calculated from the charged amount of each component in production of the polyimide resin.

The polyimide resin powders obtained in Examples 2 to 4 and Comparative Examples 1 to 6, which will be described later, had the same composition and evaluation results as the polyimide resin powder of Example 1 shown in Table 1.

Table 1

| | | Tetracarboxylic acid component (mol% in total tetracarboxylic acid component) | Diamine component (mol% in total diamine component) | | (1)/{(1)+(2)} (mol%)*1 | Tm (°C) |
|---|---|---|---|---|---|---|
| | | PMDA | 1,3-BAC | OMDA | | |
| Example 1 | Polyimide resin | 100 | 35 | 65 | 35 | 323 |
| *1: Content ratio (mol%) of the repeating structural unit of the formula (1) with respect to the total of the repeating structural unit of the formula (1) and the repeating structural unit of the formula (2) in the polyimide resin | | | | | | |

The abbreviations in the table 1 are as follows.

- PMDA; pyromellitic dianhydride
- 1,3-BAC; 1,3-bis(aminomethyl)cyclohexane
- OMDA; 1,8-octamethylenediamine

[Example 2]

A polyimide resin powder was obtained in the same manner as in Example 1, except that in the process of increasing the temperature of the polyamic acid solution (c) to 190°C, the average heating rate in the solution temperature range of 70 to 130°C was changed as shown in Table 2.

[Example 3]

A polyimide resin powder was obtained in the same manner as in Example 1, except that the amount of the 2-(2-methoxyethoxy)ethanol added to the pyromellitic dianhydride was 665g, the amount of the 2-(2-methoxyethoxy)ethanol added to the mixed diamine was 208 g, and the amount of the 2-(2-methoxyethoxy)ethanol added after the dropping had finished was 84 g.

[Example 4]

A polyimide resin powder was obtained in the same manner as in Example 3, except that in the process of increasing the temperature of the polyamic acid solution (c) to 190°C, the average heating rate in the solution temperature range of 70 to 130°C was changed as shown in Table 2.

[Comparative Example 1]

A polyimide resin powder was obtained in the same manner as in Example 1, except that the amount of the pyromellitic dianhydride was 76.69 g (0.353 mol), the amount of the 1,3-bis(aminomethyl)cyclohexane was 17.57 g (0.123 mol), the amount of 1,8-octamethylenediamine was 33.09 g (0.229 mol), and the amount of the n-octylamine was 0.453 g (0.00352 mol).

[Comparative Example 2]

A polyimide resin powder was obtained in the same manner as in Example 1, except that the amount of the pyromellitic dianhydride was 295.3 g (1.359 mol), the amount of the 1,3-bis(aminomethyl)cyclohexane was 67.64 g (0.474 mol), the amount of the 1,8-octamethylenediamine was 127.4 g (0.882 mol), and the amount of the n-octylamine was 1.74 g (0.0136 mol).

[Comparative Examples 3 to 6]

Polyimide resin powders were obtained in the same manner as in Comparative Example 2, except that in the process of increasing the temperature of the polyamic acid solution (c) to 190°C, the average heating rate in the solution temperature range of 70 to 130°C was changed as shown in Table 2.

For the polyimide resin powders obtained in Examples 1 to 4 and Comparative Examples 1 to 6, the results of the volume average particle sizes D10, D50, and D90 are shown in Table 2, and the results of the particle size distributions are shown in Figs. 1 to 10. The shapes of the particle size distributions were evaluated according to the following criteria, and are shown in Table 2.

A: Unimodal distribution, very sharp
(D10/D50 is 0.7 to 0.9 and D90/D50 is 1.1 to 1.4)
B: Unimodal distribution, sharp
(D10/D50 is 0.45 to 0.9 and D90/D50 is more than 1.4 and 2.0 or less)
C: Bimodal distribution, sharp main peak
(although the distribution is bimodal, D10/D50 is 0.45 to 0.9 and D90/D50 is more than 1.4 and 2.0 or less)
D: Bimodal distribution, very broad
(D10/D50 is 0.45 to 0.9 and D90/D50 exceeded 2.0)
E: Trimodal or more multimodal distribution

Table 2 Production conditions and evaluation results of polyimide resin powder

| | | | Example 1 | Example 2 | Example 3 | Example 4 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|
| Production conditions of polyimide resin powder | Solid content concentration in the polyamic acid solution (c) | % by mass | 21 | 21 | 25 | 25 | 10 | 30 | 30 | 30 | 30 | 30 |
| | Average heating rate | °C/min | 0.91 | 3.2 | 0.9 | 3.6 | 3.0 | 0.44 | 0.88 | 1.09 | 1.36 | 1.8 |
| Evaluation results of polyimide resin powder | Volume average particle size D10 | μm | 11.4 | 21.4 | 6.96 | 16.8 | 23.2 | 1.64 | 3.87 | 2.88 | 3.87 | 4.51 |
| | Volume average particle size D50 | μm | 15.1 | 26.9 | 14.3 | 25.9 | 52.8 | 4.57 | 7.4 | 7.2 | 9.44 | 11.1 |
| | Volume average particle size D90 | μm | 19.8 | 34 | 25.2 | 38.6 | 419 | 12.4 | 23.4 | 17.7 | 23.4 | 23.6 |
| | D101D50 | - | 0.75 | 0.80 | 0.49 | 0.65 | 0.44 | 0.36 | 0.52 | 0.40 | 0.41 | 0.41 |
| | D90/D50 | - | 1.31 | 1.26 | 1.76 | 1.49 | 7.94 | 2.71 | 3.16 | 2.46 | 2.48 | 2.13 |
| | Particle size distribution | - | A | A | C | B | E | D | D | D | D | D |

From the results listed in Table 2, the following can be seen.

In Examples 1 to 4, by setting the solid content concentration of the solution (c) containing the polyimide resin precursor containing the polyamic acid in a specific range (15 to 25% by mass), and setting the average heating rate in a specific range (0.5 to 8 °C/min) in the temperature range (70 to 130°C) when heating the solution (c) to imidate the polyimide resin precursor containing the polyamic acid, polyimide resin powders having a volume average particle size D50 within a specific range (specifically from 5 to 50 μm) and a good particle size distribution were obtained. In particular, in Examples 1 and 2, polyimide resin powders having a unimodal and very sharp particle size distribution were obtained.

On the other hand, in Comparative Examples 1 to 6, the polyimide resin powders were produced based on conditions in which the solid content concentration of the solution (c) containing the polyimide resin precursor containing the polyamic acid was outside the specific range, and so polyimide resin powders having a volume average particle size D50 within the specific range (specifically from 5 to 50 μm) and a good particle size distribution were not obtained. In particular, in Comparative Example 1, only a polyimide resin powder having a trimodal or more multimodal particle size distribution was obtained.

[Example 5]

<Production of resin film>

The polyimide resin powder obtained in Example 1 was extruded using a twin-screw kneading extruder "TEM58SX" (produced by Shibaura Machine Co., Ltd.) at a barrel temperature of from 250 to 330°C and a screw rotation speed of 100 rpm. The strands extruded from the extruder were air-cooled, and then pelletized by a pelletizer ("Fan Cutter fcwn30-12", produced by Hoshi Plastics Co., Ltd.). The obtained pellets of the polyimide resin powder (hereinafter, sometimes simply referred to as "pellets") were dried at 150°C for 12 hours. The pellets obtained had a length of 3 to 4 mm and a diameter of 2 to 3 mm.

A resin film having a thickness of 50 μm was obtained by feeding the dried pellets into a φ 40mm single-screw extruder equipped with a T-die having a width of 900 mm and melt-kneading at a resin temperature of from 340 to 360°C, continuously extruding the melt-kneaded polyimide resin from the T-die of the single-screw extruder, and then cooling with a metal roll, which is a cooling roll having a temperature of 150°C. The resin film obtained had a saturated water absorption of 0.75%.

The temperature of the φ40 mm single-screw extruder herein was adjusted to 340 to 355°C, the temperature of the T-die was adjusted to 355°C, and the temperature of the connecting pipe connecting the single-screw extruder and the T-die was adjusted to 355°C.

Table 3 shows the results of the dielectric properties of the resin film of Example 5 obtained using the polyimide resin powder obtained in Example 1. For reference, Table 4 shows the results of the dielectric properties of the resin film of Example 1 obtained using the thermoplastic liquid crystal polymer disclosed in JP 2018-109090 A.

Table 3 Dielectric properties of resin film containing polyimide resin

| | Measurement temperature (°C) | -40 | 23 | 40 | 80 | 100 | 120 | 140 | 150 |
|---|---|---|---|---|---|---|---|---|---|
| Frequency 10 GHz | Dielectric constant P | 2.723 | 2.704 | 2.699 | 2.686 | 2.684 | 2.682 | 2.679 | 2.680 |
| | Dielectric loss tangent Q | 0.0010 | 0.0016 | 0.0017 | 0.002 | 0.0021 | 0.0022 | 0.0024 | 0.0025 |
| Frequency 20 GHz | Dielectric constant P | 2.85 | 2.836 | 2.826 | - | - | 2.806 | 2.803 | 2.801 |
| | Dielectric loss tangent Q | 0.0010 | 0.0016 | 0.0016 | - | - | 0.0024 | 0.0026 | 0.0027 |
| Frequency 10 GHz | $P_{120}/P_{40}$ | | | | | 0.99 | | | |
| | $Q_{120}/Q_{40}$ | | | | | 1.29 | | | |
| Frequency 20 GHz | $P_{120}/P_{40}$ | | | | | 0.99 | | | |
| | $Q_{120}/Q_{40}$ | | | | | 1.50 | | | |

Table 4 Dielectric properties of resin film containing liquid crystal polymer

| | Measurement temperature (°C) | 40 | 120 |
|---|---|---|---|
| Frequency 20 GHz | Dielectric constant P | 3.52 | 3.52 |
| | Dielectric loss tangent Q | 0.001 | 0.003 |
| Frequency 20 GHz | $P_{120}/P_{40}$ | | 1 |
| | $Q_{120}/Q_{40}$ | | 3 |

It can be seen that the resin film (containing the polyimide resin) shown in Table 3 has a ratio of the dielectric loss tangent $Q_{40}$ at 40°C and the dielectric loss tangent $Q_{120}$ at 120°C, $Q_{120}/Q_{40}$, at 10 GHz of 1.29, and a ratio of the dielectric loss tangent $Q_{40}$ at 40°C and the dielectric loss tangent $Q_{120}$ at 120°C, $Q_{120}/Q_{40}$, at 20 GHz of 1.5. Therefore, according to the resin film of Example 5 obtained using the polyimide resin powder of Example 1, it has been shown that an increase in the dielectric loss tangent at high temperatures can be suppressed. The measurement results of the dielectric constant P and the dielectric loss tangent Q at each temperature at the measurement frequency of 10 GHz of the resin film of Example 5 shown in Table 3 are shown in Fig. 11, and the measurement results of the dielectric constant P and the dielectric loss tangent Q at each temperature at the measurement frequency of 20 GHz are shown in Fig. 12.
On the other hand, Table 4 shows the dielectric properties of the resin film of Example 1 obtained using the thermoplastic liquid crystal polymer of JP 2018-109090 A.
It can be seen that the resin film (containing the thermoplastic liquid crystal polymer) shown in Table 4 has a ratio between the dielectric loss tangent $Q_{40}$ at 40°C and the dielectric loss tangent $Q_{120}$ at 120°C, $Q_{120}/Q_{40}$, at 20 GHz of 3.
From the above, it has been shown that the resin film (containing polyimide resin) shown in Table 3 is also more effective in suppressing the increase in the dielectric loss tangent at high temperatures than the resin film (containing the thermoplastic liquid crystal polymer) shown in Table 4.

[Example 6]

<Production of copper clad laminate>

The resin film having a thickness of 50 μm obtained in Example 5 was cut into an A4 size and used to produce a copper clad laminate.
The above resin film and a 12 μm-thick rolled copper foil ("BHM-102F-HA-V2", produced by JX Nippon Mining & Metals Corporation, A4 size, Rz of welded surface with the resin film: 0.67 μm) were stacked in the order of copper foil, resin film, copper foil. Using a laboratory double belt press machine produced by Dymco, Ltd., this stack was laminated by holding for 10 seconds at a heating temperature of 300°C and a pressure of 0.22 MPa to produce a copper clad laminate having a three-layer structure of, in order, a copper foil layer, a resin film layer, and a copper foil layer. For the obtained copper clad laminate, the adhesiveness between the resin film and the copper foil was measured by a 90° peel test (JIS K6854-1: 1999). Further, the appearance of the copper clad laminate was evaluated by visual observation as to the presence or absence of wrinkles.
The adhesiveness between the resin film and the copper foil and the appearance were both evaluated based on four grades of AA, A, B, and C using the evaluation results of Example 6 as the "A" standard.

[Examples 7 to 10]

Copper clad laminates were produced and evaluated in the same manner as in Example 6, except that the copper foil used, the equipment used, and the lamination conditions of the resin film and copper foils were changed as shown in Table 5. The results are shown in Table 5.
The copper foils listed in Table 5 and the equipment used were as follows.

(Copper foil)

- Rolled copper foil (BHM-102F-HA-V2) produced by JX Nippon Mining & Metals Corporation, A4 size, Rz of welding surface with resin film: 0.67 μm, thickness 12 μm
- Electrolytic copper foil (TQ-M5-VSP) produced by Mitsui Mining & Smelting Co., Ltd., A4 size, Rz of welding surface

with resin film: 0.70 μm, thickness 12 μm

(Equipment used)

- Laboratory double belt press machine produced by Dymco, Ltd.
- Vacuum press machine produced by Kodaira Seisakusho, Co., Ltd.

Table 5

| | | Example 6 | Example 7 | Example 8 | Example 9 | Example 10 |
|---|---|---|---|---|---|---|
| Copper foil | | rolled copper foil | electrolytic copper foil | rolled copper foil | rolled copper foil | rolled copper foil |
| Apparatus used | | double belt press machine | double belt press machine | double belt press machine | double belt press machine | vacuum press machine |
| Lamination conditions | Heating temperature (°C) | 300 | 300 | 290 | 280 | 320 |
| | Pressure (MPa) | 0.22 | 0.22 | 0.22 | 0.22 | 0.4 |
| | Holding time or press time (seconds) | 10 | 10 | 60 | 60 | 60 |
| Evaluation results | Adhesiveness between resin film and copper foil | A | A | B | B | AA |
| | Appearance | A | A | B | C | C |

Industrial Applicability

According to the production method of the present invention, it is possible to obtain a polyimide resin powder having a volume average particle size D50 within a specific range (specifically from 5 to 50 μm) and a good particle size distribution. Further, according to the resin film obtained by using the polyimide resin powder having the specific composition obtained by the production method of the present invention, it is possible to suppress the increase in dielectric loss tangent under high temperatures.

The resin film can be applied to, for example, a high-frequency circuit board, a copper clad laminate (CCL), in particular a copper clad laminate that uses a low-roughness (arithmetic average roughness Ra = 1 μm or less, maximum height Rz = 1 μm or less) copper foil, a printed circuit board, a transmission lines such as a coaxial line, a strip line, a microstrip line, a coplanar line, and a parallel line, a microwave antenna, a millimeter wave antenna, a waveguide slot antenna, a horn antenna, a lens antenna, a printed antenna, a triplate antenna, a microstrip antenna, a patch antenna, various sensors, an automotive radar, an aerospace radar, a semiconductor device material, a coating for a bearing, a heat insulating shaft, a tray, various belts such as a seamless belt, a heat-resistant low-dielectric tape, a heat-resistant low-dielectric tube, a low-dielectric wire coating material, a radome (radar dome), a 5G smartphone/5G terminal antenna board, a 6G smartphone/6G terminal antenna board, a chip-on-film (COF) flexible board, an optical communication module (TOSA/ROSA), a 77 GHz in-vehicle millimeter wave radar antenna board, a terahertz wave radar antenna board, an aircraft radar antenna board, a tracked vehicle antenna board, an 8K-TV cable, a WiGig antenna board, a tablet terminal, a laptop PC, a flat-screen TV, a roll-up TV, a mobile terminal or digital home appliance such as a digital camera, a macro cell base station, a small cell base station, a C-RAN base station, a commercial drone, a long-distance mobile drone, a surveillance camera, smart glasses, a smart watch, a wafers for a high-frequency device, a wireless communication device, a Wi-Fi chip, a touch sensor, an indoor server, an outdoor server, an industrial robot board, a home robot communication board, an artificial satellite, a space station communication device, and the like.

In addition, examples of applications that the powder can be used in as is include a starting material for dry blending, a starting material for compression molded products such as a packing and an IC inspection jig, a toughness

imparting agent for CFRP, a toughness imparting agent for thermosetting resins and thermoplastic resins, a heat resistance improving agent, a coating material, a lubricant, a starting material for a 3D printer, a starting material for a UD tape, and the like.

## Claims

1. A method for producing a polyimide resin powder, comprising:

   a step of reacting a tetracarboxylic acid component (A) comprising a tetracarboxylic dianhydride and a diamine component (B) comprising an aliphatic diamine in the presence of a solvent (C) comprising an alkylene glycol solvent represented by the formula (1),
   wherein the step comprises:

      separately preparing a solution (a) comprising the tetracarboxylic acid component (A) in the solvent (C) and a solution (b) comprising the diamine component (B) in the solvent (C), and then adding the solution (b) to the solution (a) or adding the solution (a) to the solution (b) to prepare a solution (c) comprising a polyimide resin precursor comprising a polyamic acid; and
      then imidizing the polyimide resin precursor comprising the polyamic acid by heating the solution (c) to deposit a polyimide resin powder in the solution,

   wherein the solution (c) has a solid content concentration of 15 to 25% by mass, and an average heating rate in a temperature range of 70 to 130°C during the heating of the solution (c) is 0.5 to 8 °C/min:

$$Ra_1-O-\left(Ra_2-O\right)_n-H \qquad (1)$$

   wherein $Ra_1$ represents a hydrogen atom or an alkyl group having from 1 to 4 carbon atoms, $Ra_2$ represents a linear alkylene group having from 2 to 6 carbon atoms, and n represents an integer of 1 to 3.

2. The method according to claim 1, wherein the alkylene glycol solvent is at least one selected from the group consisting of 2-(2-methoxyethoxy)ethanol and 2-(2-ethoxyethoxy)ethanol.

3. The method according to claim 1 or 2, wherein the diamine component (B) comprises, as the aliphatic diamine, a diamine (B1) represented by the formula (B1-1) and a diamine (B2) represented by the formula (B2-1):

$$H_2N\text{-}R_1\text{-}NH_2 \qquad (B1\text{-}1)$$

$$H_2N\text{-}R_2\text{-}NH_2 \qquad (B2\text{-}I)$$

   wherein $R_1$ represents a divalent group having from 6 to 22 carbon atoms containing at least one alicyclic hydrocarbon structure; and $R_2$ represents a divalent chain aliphatic group having from 5 to 20 carbon atoms.

4. The method according to any one of claims 1 to 3, wherein the tetracarboxylic dianhydride is represented by the formula (A-1):

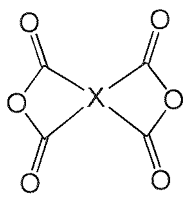

(A-1)

   wherein X represents a tetravalent group having from 6 to 22 carbon atoms containing at least one aromatic ring.

5. The method according to any one of claims 1 to 4, wherein the tetracarboxylic dianhydride is pyromellitic dianhydride.

6. The method according to any one of claims 1 to 5, wherein the solvent (C) comprises 2-ethylhexanol.

7. A polyimide resin powder produced by the method according to any one of claims 1 to 6, wherein the polyimide resin powder comprises a repeating structural unit represented by the following formula (I) and a repeating structural unit represented by the following formula (II), and a content ratio of the repeating structural unit of the formula (I) with respect to the total of the repeating structural unit of the formula (I) and the repeating structural unit of the formula (II) is 20 to 70 mol%:

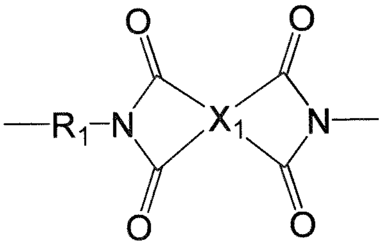

(I)

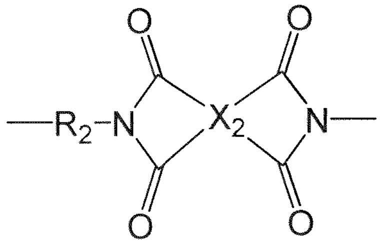

(II)

wherein $R_1$ represents a divalent group having from 6 to 22 carbon atoms containing at least one alicyclic hydrocarbon structure; $R_2$ represents a divalent chain aliphatic group having from 5 to 16 carbon atoms; and $X_1$ and $X_2$ each independently represent a tetravalent group having from 6 to 22 carbon atoms containing at least one aromatic ring.

8. The polyimide resin powder according to claim 7, wherein in the polyimide resin powder, the content ratio of the repeating structural unit of the formula (I) with respect to the total of the repeating structural unit of the formula (I) and the repeating structural unit of the formula (II) is 20 mol% or more and less than 40 mol%.

9. The polyimide resin powder according to claim 7 or 8, wherein the polyimide resin powder has a volume average particle size D50 from 13 to 35 μm.

10. A resin film obtained using a forming material comprising the polyimide resin powder according to any one of claims 7 to 9.

11. The resin film according to claim 10, wherein a ratio of a dielectric constant $P_{40}$ at 40°C and a dielectric constant $P_{120}$ at 120°C, $P_{120}/P_{40}$, at 10 GHz is from 0.8 to 1.2.

12. The resin film according to claim 10 or 11, wherein a ratio of a dielectric loss tangent $Q_{40}$ at 40°C and a dielectric loss tangent $Q_{120}$ at 120°C, $Q_{120}/Q_{40}$, at 10 GHz is from 1.0 to 1.5.

13. The resin film according to any one of claims 10 to 12, wherein a ratio of a dielectric constant $P_{40}$ at 40°C and a dielectric constant $P_{120}$ at 120°C, $P_{120}/P_{40}$, at 20 GHz is from 0.8 to 1.2.

14. The resin film according to any one of claims 10 to 13, wherein a ratio of a dielectric loss tangent $Q_{40}$ at 40°C and a dielectric loss tangent $Q_{120}$ at 120°C, $Q_{120}/Q_{40}$, at 20 GHz is from 1.0 to 1.7.

15. A high-frequency circuit board comprising the resin film according to any one of claims 10 to 14.

16. A copper clad laminate comprising a layer comprising the resin film according to any one of claims 10 to 14.

[Fig. 1]

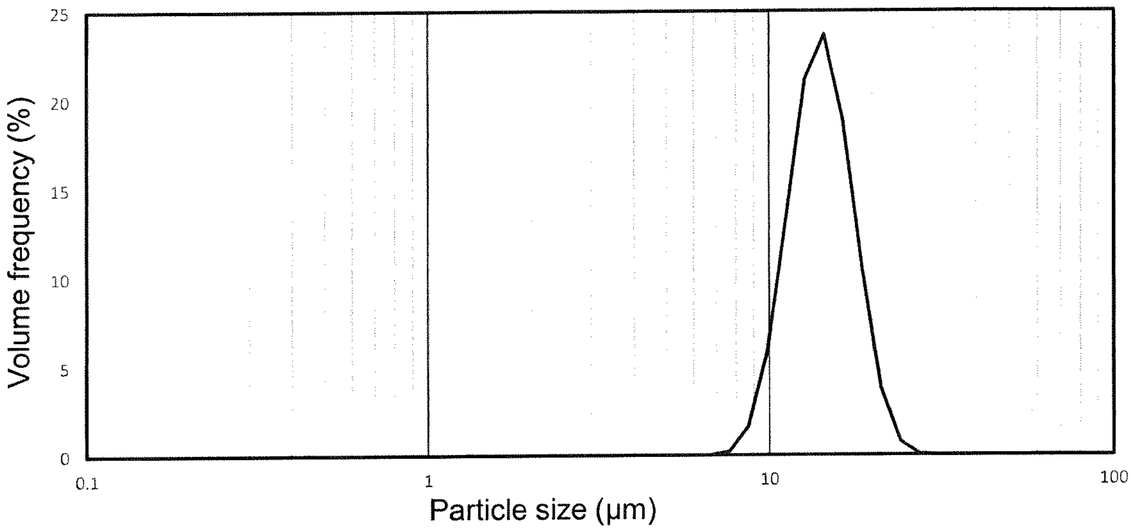
25
20
15
10
5
0
Volume frequency (%)
0.1
1
10
100
Particle size (μm)

[Fig. 2]

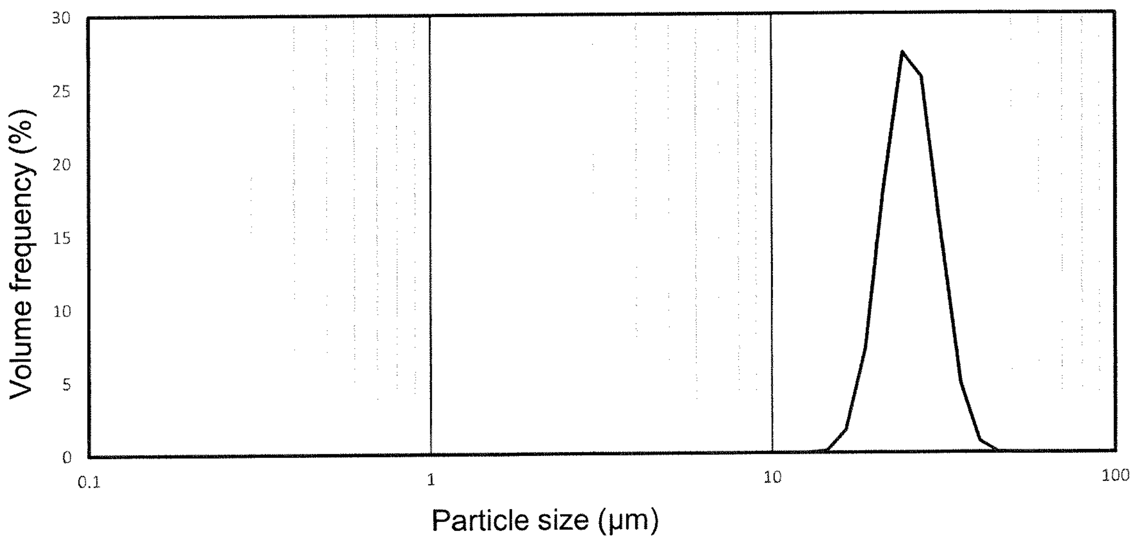
30
25
20
15
10
5
0
Volume frequency (%)
0.1
1
10
100
Particle size (μm)

[Fig. 3]

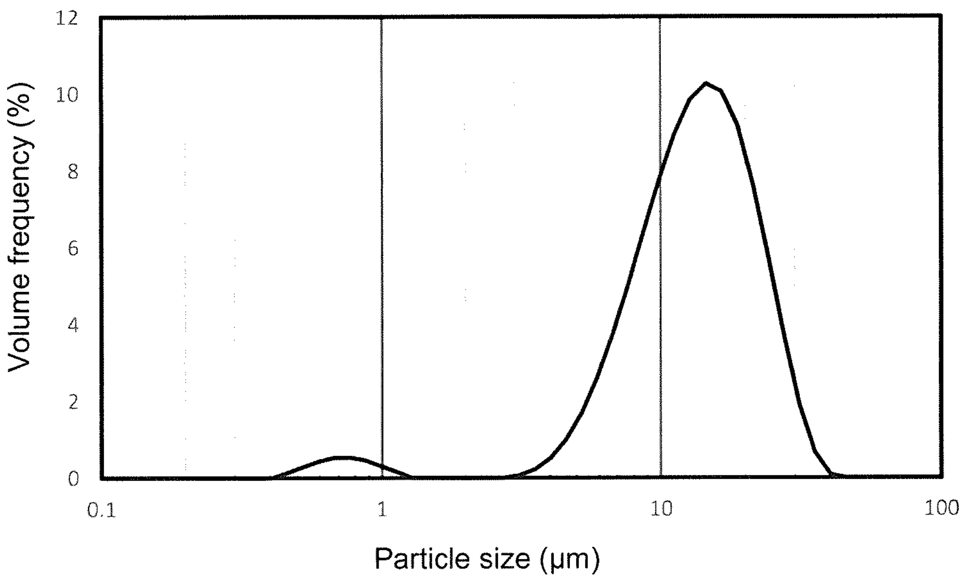
12
10
8
6
4
2
0
Volume frequency (%)
0.1
1
10
100
Particle size (µm)

[Fig. 4]

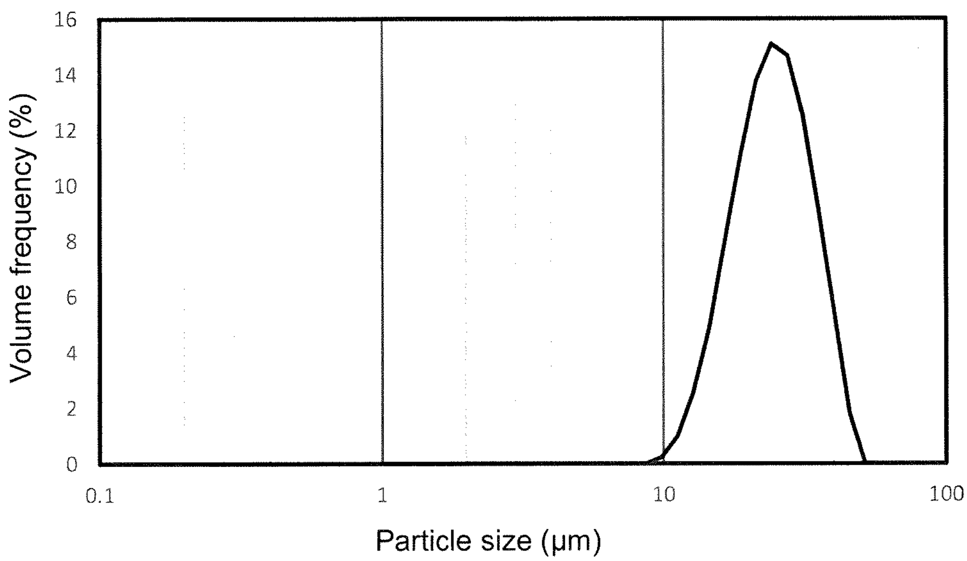
16
14
12
10
8
6
4
2
0
Volume frequency (%)
0.1
1
10
100
Particle size (µm)

[Fig. 5]

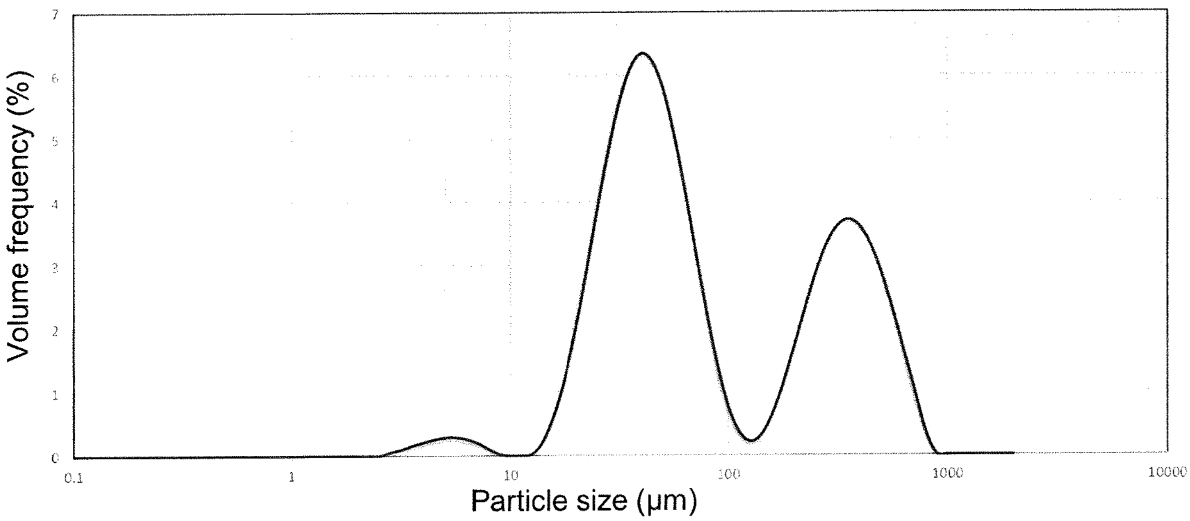
Volume frequency (%)
Particle size (μm)
0
1
2
3
4
5
6
7
0.1
1
10
100
1000
10000

[Fig. 6]

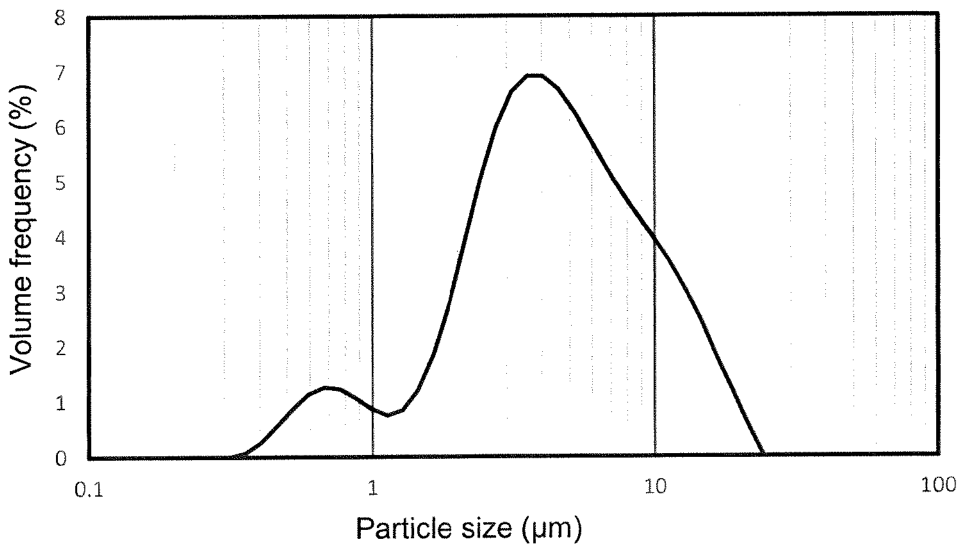
Volume frequency (%)
Particle size (μm)
0
1
2
3
4
5
6
7
8
0.1
1
10
100

[Fig. 7]

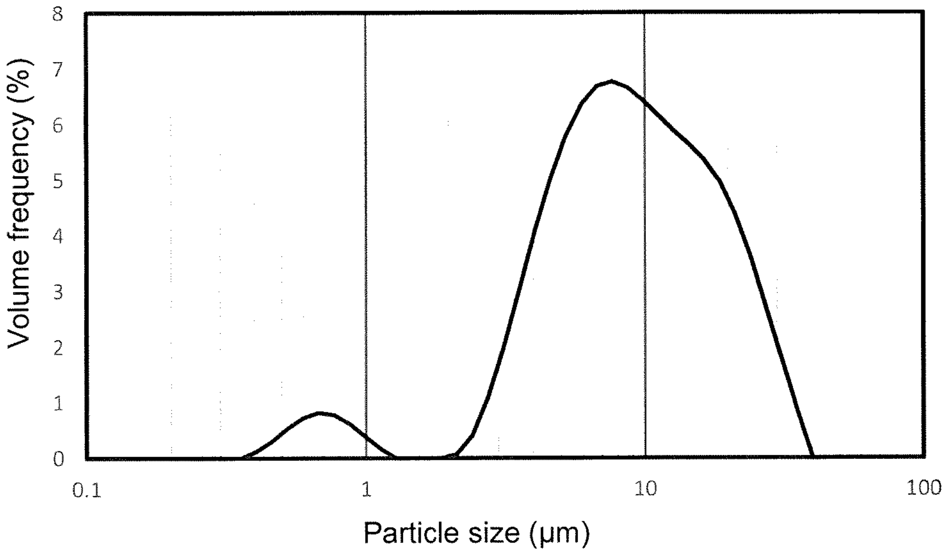
Volume frequency (%)
0
1
2
3
4
5
6
7
8
0.1
1
10
100
Particle size (μm)

[Fig. 8]

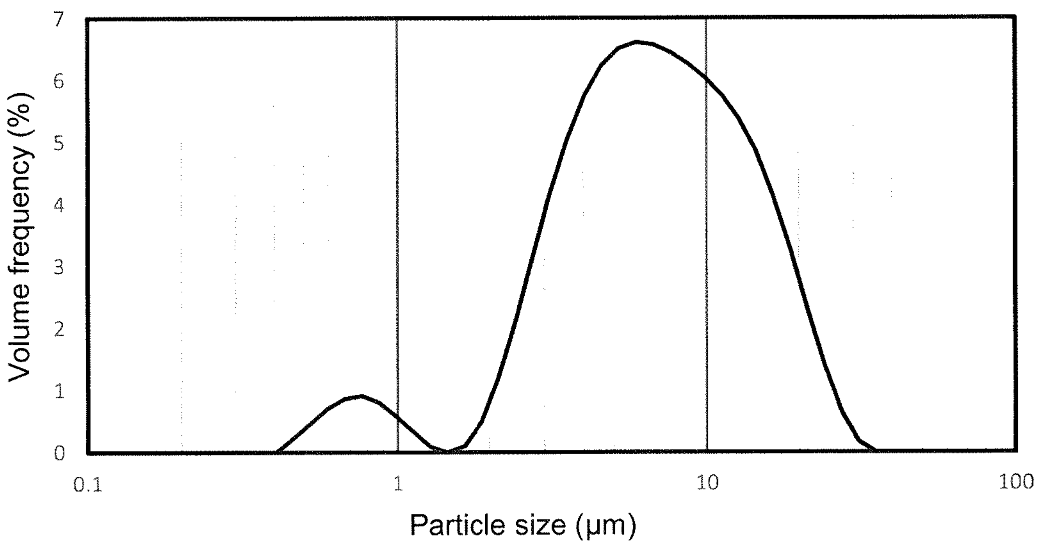
Volume frequency (%)
0
1
2
3
4
5
6
7
0.1
1
10
100
Particle size (μm)

[Fig. 9]

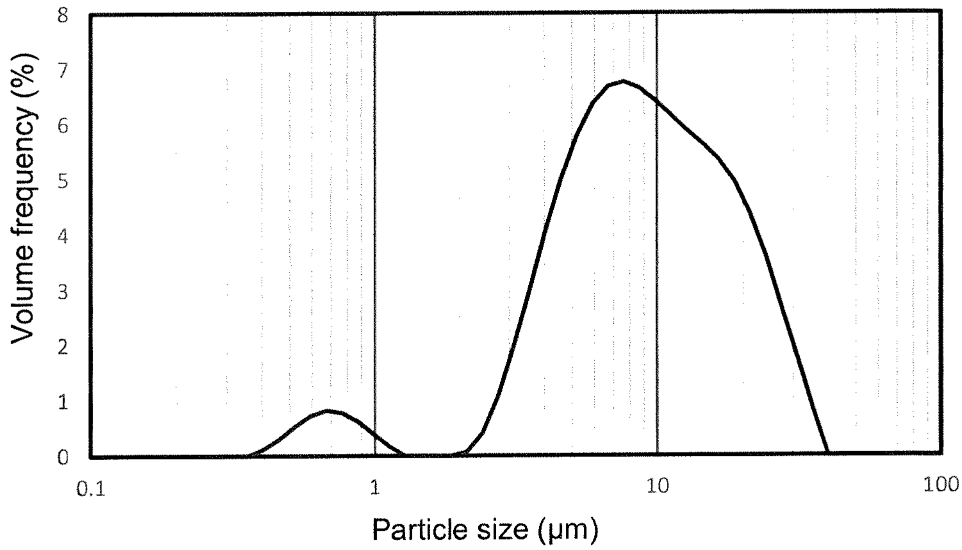
8
7
6
5
4
3
2
1
0
Volume frequency (%)
0.1
1
10
100
Particle size (μm)

[Fig. 10]

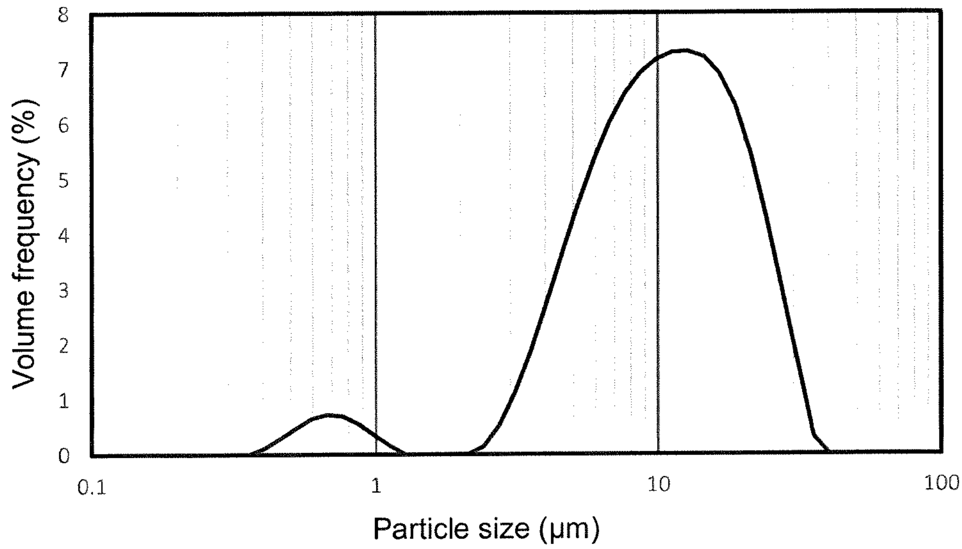
8
7
6
5
4
3
2
1
0
Volume frequency (%)
0.1
1
10
100
Particle size (μm)

[Fig. 11]

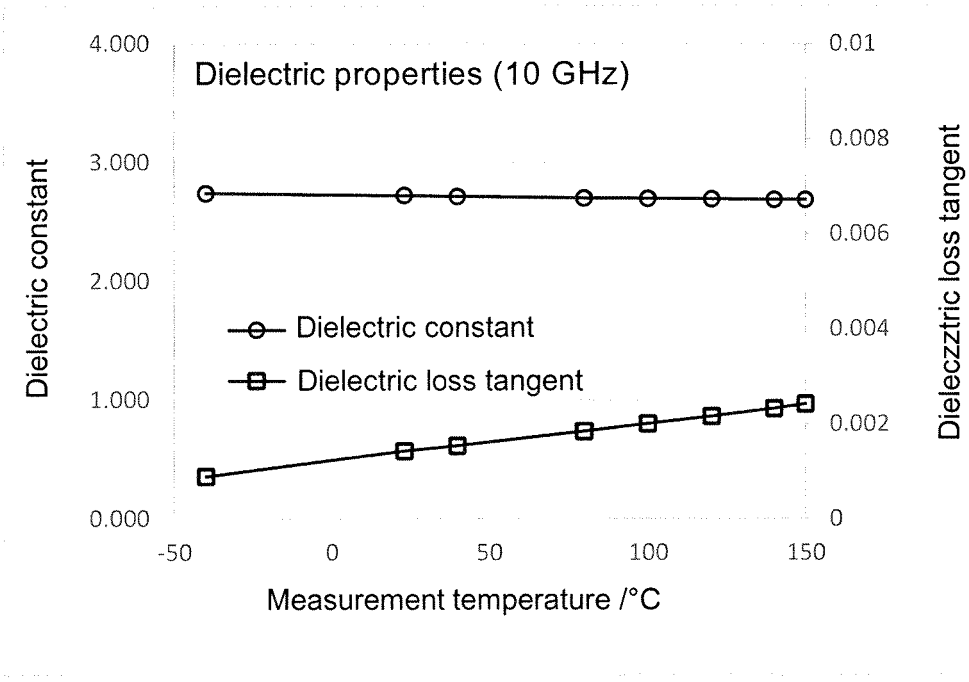
Dielectric properties (10 GHz)
Dielectric constant
Dielectric loss tangent
Dieleczztric loss tangent
Measurement temperature /°C
4.000
3.000
2.000
1.000
0.000
0.01
0.008
0.006
0.004
0.002
0
-50
0
50
100
150

[Fig. 12]

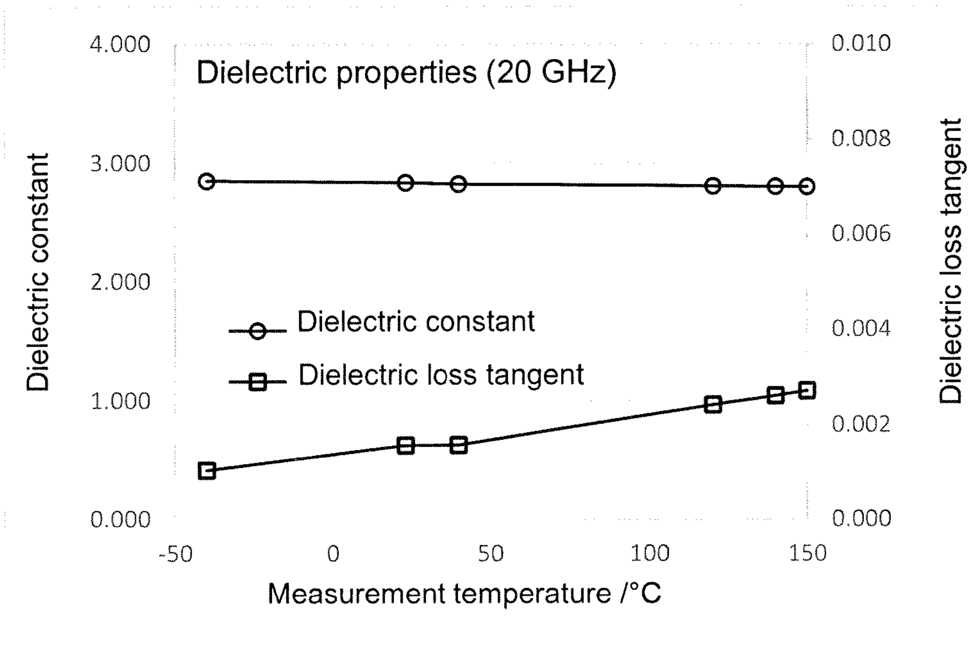
Dielectric properties (20 GHz)
Dielectric constant
Dielectric loss tangent
Dielectric loss tangent
Measurement temperature /°C
4.000
3.000
2.000
1.000
0.000
0.010
0.008
0.006
0.004
0.002
0.000
-50
0
50
100
150

## INTERNATIONAL SEARCH REPORT

International application No.
**PCT/JP2022/008643**

**A. CLASSIFICATION OF SUBJECT MATTER**

***C08G 73/10***(2006.01)i; ***C08J 5/18***(2006.01)i; ***B32B 15/088***(2006.01)i; ***H05K 1/03***(2006.01)i
FI: C08G73/10; H05K1/03 610N; H05K1/03 610P; H05K1/03 630H; B32B15/088; C08J5/18 CFG

According to International Patent Classification (IPC) or to both national classification and IPC

**B. FIELDS SEARCHED**

Minimum documentation searched (classification system followed by classification symbols)

C08G73/10; C08J5/18; B32B15/088; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2015/020019 A1 (MITSUBISHI GAS CHEMICAL COMPANY, INC) 12 February 2015 (2015-02-12)<br>entire text | 1-16 |
| A | JP 2013-144751 A (UBE INDUSTRIES LTD) 25 July 2013 (2013-07-25)<br>entire text | 1-16 |
| A | JP 7-33875 A (TOHO RAYON CO LTD) 03 February 1995 (1995-02-03)<br>entire text | 1-16 |
| A | JP 2013-23606 A (UBE INDUSTRIES LTD) 04 February 2013 (2013-02-04)<br>entire text | 1-16 |
| A | JP 7-300524 A (HITACHI CHEMICAL CO LTD) 14 November 1995 (1995-11-14)<br>entire text | 1-16 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 May 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/008643**

| Patent document cited in search report | Publication date (day/month/year) | Patent family member(s) | Publication date (day/month/year) |
|---|---|---|---|
| WO 2015/020019 A1 | 12 February 2015 | US 2016/0159984 A1<br>entire text<br>EP 3031844 A1<br>CN 105377949 A<br>KR 10-2016-0039613 A<br>TW 201509961 A | |
| JP 2013-144751 A | 25 July 2013 | WO 2013/105619 A1<br>entire text<br>TW 201339204 A | |
| JP 7-33875 A | 03 February 1995 | (Family: none) | |
| JP 2013-23606 A | 04 February 2013 | (Family: none) | |
| JP 7-300524 A | 14 November 1995 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005028524 A
- WO 2015020019 A
- JP 2020177987 A
- JP 2010 A
- JP 221694 A
- JP 2018109090 A